# EUROPEAN PATENT APPLICATION

(11) **EP 3 309 804 A1**
(43) Date of publication of application: **18.04.2018**
(21) Application number: 16807292.4
(22) Date of filing: 26.05.2016
(51) Int. Cl.: H01G 9/20, C09B 57/10, C09B 67/44

(54) **PHOTOELECTRIC CONVERSION ELEMENT, DYE-SENSITIZED SOLAR CELL, METAL COMPLEX DYE, DYE SOLUTION AND OXIDE SEMICONDUCTOR ELECTRODE**

(30) Priority: 11.06.2015 JP 2015118149
(71) Applicant: Fujifilm Corporation, Minato-ku Tokyo 106-8620 (JP)
(72) Inventor: WATANABE, Kousuke, Ashigarakami-gun Kanagawa 258-8577 (JP); HAMADA, Kazuhiro, Ashigarakami-gun Kanagawa 258-8577 (JP)
(74) Representative: Hoffmann Eitle
(86) International application number: PCT/JP2016/065582
(87) International publication number: WO 2016/199585

(57) **Abstract**

Provided are a photoelectric conversion element and a dye-sensitized solar cell, each including a photoconductor layer having semiconductor fine particles carrying a metal complex dye represented by Formula (1); and a metal complex dye, a dye solution, and an oxide semiconductor electrode.

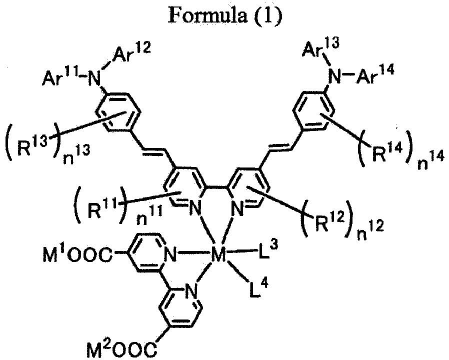

In the formula, M represents a metal ion. Ar¹¹ to Ar¹⁴ each represent a phenyl group, or a phenyl group having an alkyl group or the like, and Ar¹¹ and Ar¹² each represent different phenyl groups. R¹¹ to R¹⁴ each represent an alkyl group or the like. n¹¹ and n¹² each represent an integer of 0 to 3. n¹³ and n¹⁴ each represent an integer of 0 to 4. M¹ and M² each represent a proton or a cation, and L³ and L⁴ each represent a monodentate ligand.

## Description

### BACKGROUND OF THE INVENTION

### 1. Field of the Invention

The present invention relates to a photoelectric conversion element, a dye-sensitized solar cell, a metal complex dye, a dye solution, and an oxide semiconductor electrode.

### 2. Description of the Related Art

Photoelectric conversion elements are used in various photosensors, copying machines, photoelectrochemical cells such as solar cells, and the like. These photoelectric conversion elements have adopted various systems to be put into use, such as systems utilizing metals, systems utilizing semiconductors, systems utilizing organic pigments or dyes, or combinations of these elements. In particular, solar cells utilizing inexhaustible solar energy do not necessitate fuels, and full-fledged practicalization of solar cells as an inexhaustible clean energy is being highly expected. Above all, research and development of silicon-based solar cells have long been in progress, and many countries also support policy-wise considerations, and thus dissemination of silicon-based solar cells is still in progress. However, silicon is an inorganic material, and thus, naturally has limitations in terms of improvement of throughput, cost, and the like.

Thus, research is being vigorously carried out on photoelectrochemical cells (also referred to as dye-sensitized solar cells) using metal complex dyes. In particular, what have built momentum toward such research was the research results from Graetzel et al. of École Polytechnique Fédérale de Lausanne in Switzerland. They employed a structure in which a dye formed from a ruthenium complex was fixed on the surface of a porous titanium oxide film, and realized photoelectric conversion efficiency which was comparable to that of amorphous silicon. Thus, dye-sensitized solar cells that can be produced even without use of expensive vacuum devices have instantly attracted the attention of researchers all over the world.

Hitherto, dyes called N3, N719, and N749 (also referred to as Black Dye), Z907, and J2 have generally been developed as metal complex dyes for use in dye-sensitized solar cells.

In addition to these metal complex dyes, various metal complex dyes have been studied.

For example, JP2001-291534A specifically describes a dye (D-3) having a bipyridine ligand including a diphenylaminostyryl skeleton as an example of the metal complex dye. Further, JP2013-072079A specifically describes a dye (D-1-7a) having a bipyridine ligand including a di(tertiary butylphenyl)aminostyryl skeleton, and a dye (D-1-9a) having a bipyridine ligand including a styryl skeleton having a 3,6-di-tertiary butylcarbazolyl group as an example of the metal complex dye. The metal complex dyes described in JP2001-291534A and JP2013-072079A are described to have a high molar light absorption coefficient, and thus exhibit high conversion efficiency.

Furthermore, JP2008-021496A specifically describes a dye (40) having a bipyridine ligand including a di(methylphenyl)aminostyryl skeleton.

In addition, J. Mater. Chem., 2009, 19, p. 5364-5376 describes a dye (Ru-TPA-EO-NCS) having a bipyridine ligand including a N-(2,5,8,11-tetraoxadodecylphenyl)-N-phenylaminostyryl skeleton.

### SUMMARY OF THE INVENTION

However, increasingly performance required for photoelectric conversion elements and dye-sensitized solar cells has annually been demanded, and a further improvement in photoelectric conversion efficiency is desired. Further, the applications of the photoelectric conversion element and the dye-sensitized solar cell applications have been extended to those under a low-illumination environment in which the illuminance is lower than solar light in a clear weather, for example, a low-illumination solar light in a cloudy weather, a rainy weather, or the like, or a low-illumination environment by an illumination device, such as an indoor or fluorescent light lamp. Accordingly, it is desired that sufficient photoelectric conversion efficiency is exerted even in such a low-illumination environment. Here, the low-illuminance environment is not particularly limited, but refers to an environment with an illuminance of 10,000 lux or less.

Moreover, it could be newly found that in photoelectric conversion elements and dye-sensitized solar cells, in metal complex dyes in the related art, a deviation of photoelectric conversion efficiency at an initial time (after production) easily occurs, and the deviation could not be reduced to a satisfactory extent.

Hitherto, an improvement of photoelectric conversion efficiency has been actively studied, but there has not been substantially a finding on the relationship between the chemical structure and the photoelectric conversion efficiency of a dye, and such the finding has not been described in any of the above documents.

The present invention has an object to provide a photoelectric conversion element and a dye-sensitized solar cell, each of has a reduced deviation of photoelectric conversion efficiency among photoelectric conversion elements, and exerts excellent photoelectric conversion efficiency even in a low-illumination environment; and a metal complex dye, a dye solution, and an oxide semiconductor electrode, each used in the photoelectric conversion element and the dye-sensitized solar cell.

The present inventors have conducted various studies on a metal complex dye used for a photoelectric conversion element and a dye-sensitized solar cell, and thus, have found that it is possible to realize a photoelectric conversion element and a dye-sensitized solar cell, each of which has a reduced deviation of photoelectric conversion efficiency in the photoelectric conversion element in a case where the structure of a terminal moiety (diphenylamino group) of a ligand having a diphenylaminostyryl skeleton is made asymmetrical by introduction of a specific substituent, or the like, and exerts high photoelectric conversion efficiency even in a low-illumination environment. The present invention has been completed based on these findings.

That is, the objects of the present invention have been achieved by the following means.
<1> A photoelectric conversion element comprising:
   an electrically conductive support;
   a photoconductor layer including an electrolyte;
   a charge transfer layer including an electrolyte; and
   a counter electrode,
   in which the photoconductor layer has semiconductor fine particles carrying a metal complex dye represented by Formula (1).

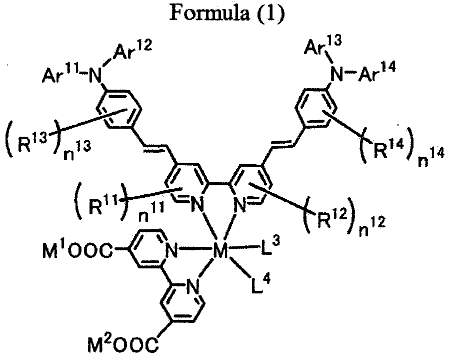

   In the formula, M represents a metal ion,
   Ar¹¹ to Ar¹⁴ each independently represent a phenyl group, or a phenyl group having any one of an alkyl group, an aryl group, an alkoxy group having one oxygen atom, an aryloxy group, an alkylthio group, an arylthio group, and a halogen atom, provided that Ar¹¹ and Ar¹² each represent different phenyl groups.
   R¹¹ and R¹² each independently represent an alkyl group, an alkoxy group, an aryl group, an alkylthio group, a heteroaryl group, an amino group, or a halogen atom. n¹¹ and n¹² each independently represent an integer of 0 to 3.
   R¹³ and R¹⁴ each independently represent an alkyl group, an alkoxy group, an aryl group, an alkylthio group, a heteroaryl group, an amino group, or a halogen atom. n¹³ and n¹⁴ each independently represent an integer of 0 to 4.
   M¹ and M² each independently represent any one of a proton, a metal cation, and a non-metal cation.
   L³ and L⁴ each independently represent a monodentate ligand.
<2> The photoelectric conversion element as described in <1>, in which Ar¹¹ is represented by any one of Formulae (2-1) to (2-5), and Ar¹² is represented by any one of Formulae (2-6) to (2-10). 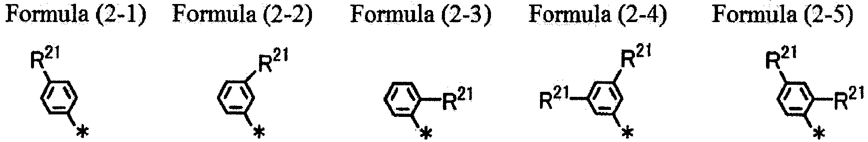
   In the formulae, R²¹ represents any one of a hydrogen atom, an alkyl group, an aryl group, an alkoxy group having one oxygen atom, and a halogen atom. * represents a bonding moiety to a nitrogen atom. 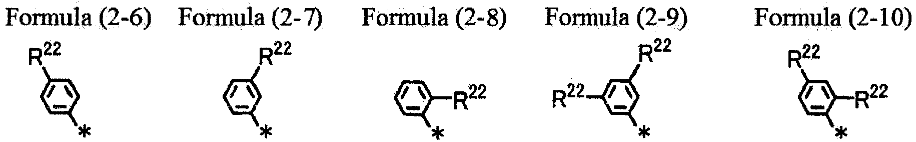
   In the formulae, R²² represents any one of an alkyl group, an aryl group, an alkoxy group having one oxygen atom, and a halogen atom. * represents a bonding moiety to a nitrogen atom.
<3> The photoelectric conversion element as described in <2>, in which Ar¹¹ is represented by Formula (2-1) or (2-2), and Ar¹² is represented by Formula (2-6) or (2-7).
<4> The photoelectric conversion element as described in <2> or <3>, in which Ar¹¹ and Ar¹³ are each represented by Formula (2-1) or (2-2), and Ar¹² and Ar¹⁴ are each represented by Formula (2-6) or (2-7).
<5> A dye-sensitized solar cell comprising the photoelectric conversion element as described in any one of <1> to <4>.
<6> A metal complex dye represented by Formula (1). 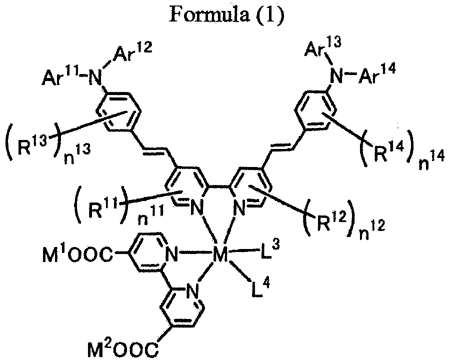
   In the formula, M represents a metal ion.
   Ar¹¹ to Ar¹⁴ each independently represent a phenyl group, or a phenyl group having any one of an alkyl group, an aryl group, an alkoxy group having one oxygen atom, an aryloxy group, an alkylthio group, an arylthio group, and a halogen atom, provided that Ar¹¹ and Ar¹² each represent different phenyl groups.
   R¹¹ and R¹² each independently represent an alkyl group, an alkoxy group, an aryl group, an alkylthio group, a heteroaryl group, an amino group, or a halogen atom. n¹¹ and n¹² each independently represent an integer of 0 to 3.
   R¹³ and R¹⁴ each independently represent an alkyl group, an alkoxy group, an aryl group, an alkylthio group, a heteroaryl group, an amino group, or a halogen atom. n¹³ and n¹⁴ each independently represent an integer of 0 to 4.
   M¹ and M² each independently represent any one of a proton, a metal cation, and a non-metal cation.
   L³ and L⁴ each independently represent a monodentate ligand.
<7> A dye solution comprising the metal complex dye as described in <6>; and a solvent.
<8> An oxide semiconductor electrode comprising the metal complex dye as described in <6>.

In the present specification, unless otherwise specified, in a case where the E configuration or the Z configuration exists in the molecule for a double bond, the double bond may be either one of the two configurations or a mixture thereof.

In a case where there are a plurality of substituents, linking groups, ligands, or the like (hereinafter referred to as substituents or the like) represented by specific symbols or formulae, or in a case where a plurality of substituents and the like are defined at the same time, the respective substituents or the like may be the same as or different from each another unless otherwise specified. This also applies to the definition of the number of substituents or the like. Further, in a case where a plurality of substituents and the like are close to each other (in particular, adjacent to each other), they may be linked to each other to form a ring, unless otherwise specified. In addition, the ring, for example, an alicycle, an aromatic ring, or a heterocycle may further be fused to form a fused ring, unless otherwise specified.

In the present specification, expressions of a compound (including a complex and a dye) are meant to encompass, in addition to the compound itself, salts and ions of the compound. Further, within a range exhibiting desired effects, the expressions are used to mean inclusion of modifications of a part of the structure. In addition, a compound in which substitution or non-substitution is not explicitly described is meant to indicate that compound may have an arbitrary substituent within a range exhibiting the desired effects. This also applies to substituents, linking groups, and ligands.

In addition, in the present specification, a numerical value range represented by "(a value) to (a value)" means a range including the numerical values represented before and after "to" as a lower limit value and an upper limit value, respectively.

By incorporating the metal complex dye represented by Formula (1) into the photoelectric conversion element and the dye-sensitized solar cell of the present invention, the deviation of photoelectric conversion efficiency among the elements is reduced, and thus, excellent photoelectric conversion efficiency even in a low-illumination environment is exerted. Accordingly, according to the present invention, it is possible to provide a photoelectric conversion element and a dye-sensitized solar cell, each of which has a reduced deviation of photoelectric conversion efficiency among the elements, and exerts photoelectric conversion efficiency even in a low-illumination environment; and a metal complex dye, a dye solution, and an oxide semiconductor electrode, each used in the photoelectric conversion element and the dye-sensitized solar cell.

The above or other characteristics and advantages of the present invention will be further clarified from the following description with reference to drawings appropriately attached hereto.

### BRIEF DESCRIPTION OF THE DRAWINGS

Fig. 1 is a cross-sectional view schematically showing a photoelectric conversion element in the first aspect of the present invention, including an enlarged view of the circled portion in a layer thereof, in a system in which the photoelectric conversion element is applied in cell uses.
Fig. 2 is a cross-sectional view schematically showing a dye-sensitized solar cell including a photoelectric conversion element in the second aspect of the present invention.

### DESCRIPTION OF THE PREFERRED EMBODIMENTS

### [Photoelectric Conversion Element and Dye-Sensitized Solar Cell]

The photoelectric conversion element of the present invention has an electrically conductive support, a photoconductor layer including an electrolyte, a charge transfer layer including an electrolyte, and a counter electrode (opposite electrode). The photoconductor layer, the charge transfer layer, and the counter electrode are provided in this order on the electrically conductive support.

In the photoelectric conversion element of the present invention, at least a portion of the semiconductor fine particles forming the photoconductor layer carries a metal complex dye represented by Formula (1) which will be described later, as a sensitizing dye. Here, the aspect in which the metal complex dye is carried on the surface of the semiconductor fine particles encompasses an aspect in which the metal complex dye is deposited on the surface of the semiconductor fine particles, an aspect in which the metal complex dye is adsorbed onto the surface of the semiconductor fine particles, and a mixture of these aspects. The adsorption encompasses chemical adsorption and physical adsorption, with the chemical adsorption being preferable.

The semiconductor fine particles may carry other metal complex dyes, together with the metal complex dye of Formula (1) which will be described later.

Moreover, the photoconductor layer includes an electrolyte. The electrolyte included in the photoconductor layer may be the same as or different from the electrolyte included in the charge transfer layer, but they are preferably the same as each other.

The photoelectric conversion element of the present invention is not particularly limited in terms of configurations other than the configuration defined in the present invention, and may adopt known configurations regarding photoelectric conversion elements. The respective layers constituting the photoelectric conversion element of the present invention are designed depending on purposes, and may be formed into, for example, a single layer or multiple layers. Further, layers other than the layers may be included, as necessary.

The dye-sensitized solar cell of the present invention is formed by using the photoelectric conversion element of the present invention.

Hereinafter, preferred embodiments of the photoelectric conversion element and the dye-sensitized solar cell of the present invention will be described.

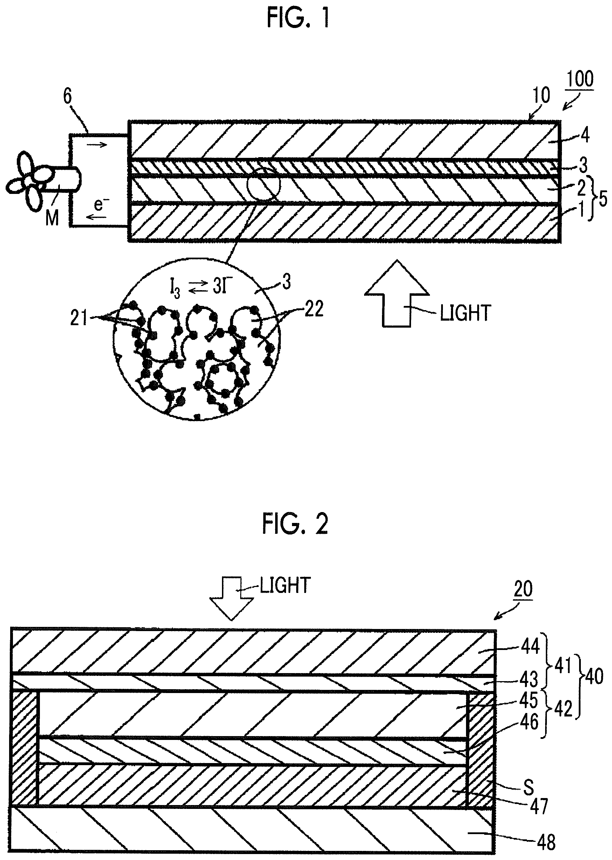

A system 100 shown in Fig. 1 is a system in which a photoelectric conversion element 10 in the first aspect of the present invention is applied in cell uses where an operating means M (for example, an electric motor) in an external circuit 6 is forced to work.

The photoelectric conversion element 10 includes semiconductor fine particles 22 sensitized by carrying an electrically conductive support 1 and a dye (metal complex dye) 21, a photoconductor layer 2 including an electrolyte between the semiconductor fine particles 22, a charge transfer layer 3 that is a hole transport layer, and a counter electrode 4.

In the photoelectric conversion element 10, the photoconductor layer 2 has the metal complex dye represented by Formula (1) adsorbed on the semiconductor fine particles 22, which is also referred to as an oxide semiconductor electrode. Further, the light-receiving electrode 5 has the electrically conductive support 1 and the photoconductor layer 2, and functions as a functional electrode.

In the system 100 in which the photoelectric conversion element 10 is applied, light incident to the photoconductor layer 2 excites the metal complex dye 21. The excited metal complex dye 21 has electrons having high energy, and these electrons are transferred from the metal complex dye 21 to a conduction band of the semiconductor fine particles 22, and further reach the electrically conductive support 1 by diffusion. At this time, the metal complex dye 21 is in an oxidized form (cation). While the electrons reaching the electrically conductive support 1 work in an external circuit 6, they reach the oxidized form of the metal complex dye 21 through the counter electrode 4 and the charge transfer layer 3, and reduce the oxidized form, whereby the system 100 functions as a solar cell.

A dye-sensitized solar cell 20 shown in Fig. 2 is constituted with a photoelectric conversion element in the second aspect of the present invention.

The photoelectric conversion element which serves as the dye-sensitized solar cell 20 is different from the photoelectric conversion element shown in Fig. 1 in the configurations of the electrically conductive support 41 and the photoconductor layer 42, and incorporation of a spacer S, but except for these, has the same structure as the photoelectric conversion element 10 shown in Fig. 1. That is, the electrically conductive support 41 has a bilayered structure including a substrate 44 and a transparent electrically-conductive film 43 which is formed on the surface of the substrate 44. Further, the photoconductor layer 42 has a bilayered structure including a semiconductor layer 45 and a light-scattering layer 46 which is formed adjacent to the semiconductor layer 45. The photoconductor layer 42 has at least the metal complex dye represented by Formula (1) adsorbed on semiconductor fine particles which form the photoconductor layer 42, for example, the semiconductor layer 45, which is also referred to as an oxide semiconductor electrode. A spacer S is provided between the electrically conductive support 41 and the counter electrode 48. In the dye-sensitized solar cell 20, 40 is a light-receiving electrode and 47 is a charge transfer layer.

In a similar manner to the system 100 in which the photoelectric conversion element 10 is applied, the dye-sensitized solar cell 20 functions as a solar cell by light incident on the photoconductor layer 42.

The photoelectric conversion element and the dye-sensitized solar cell of the present invention exhibit excellent photoelectric conversion efficiency even in a low-illumination environment, as described above. Accordingly, they can also be suitably used even in a low-illumination environment. In this case, a dye-sensitized solar cell using the photoelectric conversion element of the present invention is also referred to as a dye-sensitized photoelectrochemical cell.

The photoelectric conversion element and the dye-sensitized solar cell of the present invention are not limited to the above preferred aspects, and the configuration of each of the aspects can be combined as appropriate within a range not departing from the scope of the present invention.

In the present invention, the materials and the respective members for use in the photoelectric conversion element and the dye-sensitized solar cell can be prepared by ordinary methods. Reference can be made to, for example, US4927721A, US4684537A, US5084365A, US5350644A, US5463057A, US5525440A, JP1985-249790A (JP-H07-249790A), JP2001-185244A, JP2001-210390A, JP2003-217688A, JP2004-220974A, and JP2008-135197A.

### <Metal Complex Dye Represented by Formula (1)>

The metal complex dye of the present invention is represented by Formula (1). The metal complex dye of the present invention having such a structure can provide the photoelectric conversion element and the dye-sensitized solar cell with high photoelectric conversion efficiency, in not only a high-illumination environment, but also a low-illumination environment. Further, the metal complex dye of the present invention can reduce the deviation of photoelectric conversion efficiency at an initial time in the photoelectric conversion element and the dye-sensitized solar cell. Accordingly, the metal complex dye of the present invention is preferably used as a sensitizing dye in the dye-sensitized solar cell.

Details of the reason why the metal complex dye of the present invention can provide the photoelectric conversion element and the dye-sensitized solar cell with the excellent performance is not clarified, but is presumed as follows.

In a step of adsorbing a metal complex dye onto semiconductor fine particles such as titanium oxide, or other steps, in general, the metal complex dye is easily aggregated. In a case where an aggregate of the metal complex dye is adsorbed onto fine particles such as titanium oxide, metal complex dyes with which the semiconductor fine particles are not in contact exist. In these metal complex dyes, electrons excited after absorption of light electrons cannot be injected onto the semiconductor fine particles. As a result, the photoelectric conversion ability is reduced. Further, the deviation of photoelectric conversion efficiency among the photoelectric conversion elements is increased.

However, it is considered that the metal complex dye of the present invention has a reduced crystallinity of the metal complex dye since the diphenylamino group positioned at the terminal of a ligand having a diphenylaminostyryl skeleton becomes asymmetrical. As a result, in a step of adsorbing the metal complex dye onto the semiconductor fine particles, aggregation of the metal complex dye is suppressed. The metal complex dye not aggregated as above is adsorbed onto the surface of the semiconductor fine particles in the state where the metal complex dye is close to a monolayer, and thus, excited electrons can be efficiently injected into the semiconductor fine particles. This results in realization of high photoelectric conversion efficiency, and thus, a sufficient value thereof is exhibited even in a low-illumination environment. In addition, it is considered that the deviation of photoelectric conversion efficiency among the photoelectric conversion elements is also reduced.

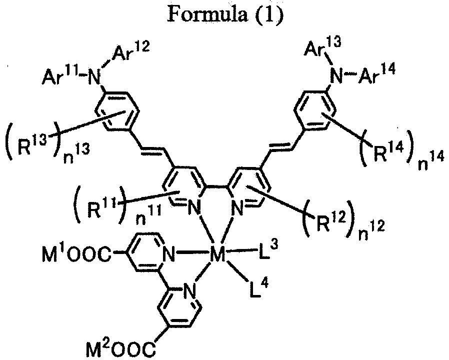

In the present invention, in a case where the metal complex dye represented by Formula (1) exists as an isomer such as an optical isomer, a geometric isomer, a bond isomer, and an ionized isomer, it may be any of these isomers or a mixture of these isomers.

In Formula (1), M represents a metal ion, and examples thereof include ions of elements belonging to Groups 6 to 12 on the long-form periodic table of the elements. Examples of such a metal ion include respective ions of Ru, Fe, Os, Cu, W, Cr, Mo, Ni, Pd, Pt, Co, Ir, Rh, Re, Mn, and Zn. The metal ion M may be one kind of ion, or two or more kinds of ions.

In the present invention, the metal ion M is preferably Os²⁺, Ru²⁺, or Fe²⁺, more preferably Os²⁺ or Ru²⁺, and particularly preferably Ru²⁺ among them.

In addition, in a state of being incorporated in the photoelectric conversion element, the valence of M may be changed by the redox reaction with the surrounding material in some cases.

Ar¹¹ to Ar¹⁴ each represent a phenyl group which may have any one of an alkyl group, an aryl group, an alkoxy group having one oxygen atom, an aryloxy group, an alkylthio group, an arylthio group, and a halogen atom. Ar¹¹ to Ar¹⁴ each preferably represent an unsubstituted phenyl group, or a phenyl group having any one of an alkyl group, an aryl group, an alkoxy group having one oxygen atom, an aryloxy group, an alkylthio group, an arylthio group, and a halogen atom.

The substituent or atom which can substitute each phenyl group of Ar¹¹ to Ar¹⁴ may be at least one of the group or atom, and the number of the substituents or atoms is preferably 1 to 4, and more preferably 1 or 2. In a case where the phenyl group has two or more substituents or atoms, the substituents or atoms may be the same as or different from each other.

The position at which each phenyl group of Ar¹¹ to Ar¹⁴ is substituted is not particularly limited. The position with the ring-constituting carbon atom bonded to an N atom may be any one of an ortho-position (o-), a meta-position (m-), and a para-position (p-), and is preferably a meta-position (m-) or a para-position (p-). In a case where the phenyl group is substituted with two substituents, the substitution positions are preferably an ortho-position and a para-position, or both are preferably meta-positions.

As each phenyl group of Ar¹¹ to Ar¹⁴, among those described above, a phenyl group, a phenyl group having an alkyl group, a phenyl group having an aryl group, a phenyl group having an alkoxy group having one oxygen atom, or a phenyl group having a halogen atom is preferable, a phenyl group, a phenyl group having an alkyl group, a phenyl group having an aryl group, and a phenyl group having a halogen atom is more preferable, and a phenyl group, a phenyl group having an alkyl group, or a phenyl group having an aryl group is still more preferable.

Ar¹¹ and Ar¹², and Ar¹³ and Ar¹⁴ may be directly bonded to each other or via a linking group. The linking group is not particularly limited, and examples thereof include -O-, -S-, -NR^{NR}-, -C(R^{NR})₂-, and -Si(R^{NR})₂-. Here, examples of R^{NR} include a group selected from the substituent group T.

In the present invention, it is preferable that Ar¹¹ and Ar¹², and Ar¹³ and Ar¹⁴ are not bonded to each other.

In the present invention, in views of improvement of photoelectric conversion efficiency and reduction in deviation, it is preferable that Ar¹¹ and Ar¹² are a combination of different phenyl groups, and Ar¹¹ and Ar¹², and Ar¹³ and Ar¹⁴ both are a combination of different phenyl groups.

In the present invention, the different phenyl groups mean that two phenyl groups of Ar¹¹ and Ar¹² have different structures. Examples thereof include an aspect in which the two phenyl groups are different depending on the presence or absence of the substituent, an aspect in which the two phenyl groups are different depending on the type or number of the substituents, an aspect in which the two phenyl groups are different depending on the substitution position of the substituent, and an aspect in which the two phenyl groups are different depending on the length or shape of the substituent.

In the present invention, it is not necessary that Ar¹¹ and Ar¹², and Ar¹³ and Ar¹⁴ be clearly distinguished, and the regulations of Ar¹¹ and Ar¹² may be applied to Ar¹³ and Ar¹⁴ in some cases. For example, a combination of Ar¹¹ and Ar¹² are different phenyl groups means that any one pair of a pair of Ar¹¹ and Ar¹², and a pair of Ar¹³ and Ar¹⁴ have different phenyl groups.

Preferred aspects or preferred combinations of Ar¹¹ to Ar¹⁴ will be described.

Ar¹¹ is preferably represented by any one of Formulae (2-1) to (2-5), and Ar¹² is preferably represented by any one of Formulae (2-6) to (2-10).

In the present invention, an amino group having Ar¹¹ and Ar¹², and an amino group having Ar¹³ and Ar¹⁴ may be the same as or different from each other.

Among those, it is preferable that the pair of Ar¹¹ and Ar¹² is the following combination, and it is more preferable that the pair of Ar¹¹ and Ar¹², and the pair of Ar¹³ and Ar¹⁴ are both the following combination.

In the pair of Ar¹¹ and Ar¹², a combination such that Ar¹¹ is represented by any one of Formulae (2-1) to (2-5), and Ar¹² is represented by any one of Formulae (2-6) to (2-10) is preferable, and a combination such that Ar¹¹ is represented by Formula (2-1) or (2-2), and Ar¹² is represented by Formula (2-6) or (2-7) is more preferable.

In the pair of Ar¹³ and Ar¹⁴, a combination such that Ar¹³ is represented by any one of Formulae (2-1) to (2-5), and Ar¹⁴ is represented by any one of Formulae (2-6) to (2-10) is preferable, and a combination such that Ar¹³ is represented by Formula (2-1) or (2-2), and Ar¹⁴ is represented by Formula (2-6) or (2-7) is more preferable.

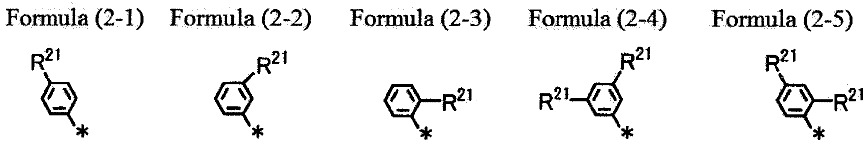

In the formula, * represents a bonding moiety to a nitrogen atom.

R²¹ represents any one of a hydrogen atom, an alkyl group, an aryl group, an alkoxy group having one oxygen atom, and a halogen atom. R²¹ is preferably a hydrogen atom, an alkyl group, an aryl group, or a halogen atom, and more preferably a hydrogen atom, an alkyl group, or an aryl group.

In Formulae (2-4) and (2-5), two R²¹'s may be the same as or different from each other.

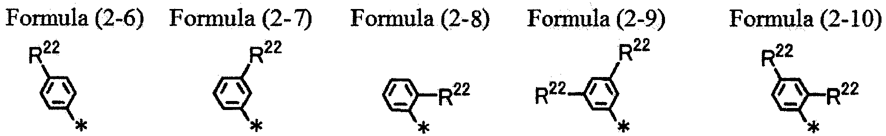

In the formula, * represents a bonding moiety to a nitrogen atom.

R²² represents any one of an alkyl group, an aryl group, an alkoxy group having one oxygen atom, and a halogen atom. R²² is preferably an alkyl group, an aryl group, or a halogen atom, and more preferably an alkyl group or an aryl group.

In Formulae (2-9) and (2-10), two R²²'s may be the same as or different from each other.

Examples of the alkyl group which can be contained in the phenyl group of each of Ar¹¹ to Ar¹⁴, and the alkyl group which can be adopted as each of R²¹ and R²² include a linear alkyl group, a branched alkyl group, and a cyclic (cyclo)alkyl group.

The number of carbon atoms in the linear alkyl group or the branched alkyl group is preferably 1 to 30, more preferably 2 to 26, still more preferably 3 to 20, and particularly preferably 3 to 12. Examples of the linear alkyl group or the branched alkyl group include methyl, ethyl, n-butyl, t-butyl, n-pentyl, 2,2-dimethylpropyl, n-hexyl, cyclohexyl, n-octyl, 2-ethylhexyl, 3-ethylheptyl, 2-butyloctyl, n-decyl, 3,7-dimethyloctyl, isodecyl, s-decyl, n-dodecyl, 2-butyloctyl, n-hexadecyl, isohexadecyl, n-eicosyl, n-hexacosyl, isooctacosyl, trifluoromethyl, and pentafluoroethyl.

The number of carbon atoms in the cyclic alkyl group is preferably 3 to 30, more preferably 5 to 30, still more preferably 6 to 26, and particularly preferably 6 to 20. Examples of the cyclic alkyl group include cyclopropyl, cyclopentyl, cyclohexyl, cycloheptyl, and cyclooctyl. The cyclic alkyl group may be fused with an alicycle, an aromatic ring, or a heterocycle.

The alkyl group may be further substituted with a group selected from the substituent group T which will be described later. The substituent is preferably a halogen atom, and more preferably a fluorine atom.

The aryl group which can be contained in the phenyl group of each of Ar¹¹ to Ar¹⁴, and the aryl group which can be adopted as each of R²¹ and R²² is a ring formed of an aromatic hydrocarbon ring, and examples thereof includes a monocyclic phenyl group and a fused polycyclic group. The number of carbon atoms in the aryl group is preferably 6 to 30, more preferably 6 to 10, and particularly preferably 6, and specific examples of such the aryl group include phenyl and naphthyl.

The aryl group may be further substituted with a group selected from the substituent group T which will be described later.

The alkoxy group which can be contained in the phenyl group of each of Ar¹¹ to Ar¹⁴, and the alkoxy group which can be adopted as each of R²¹ and R²² is an alkoxy group (an alkoxy group having one oxygen atom) which is bonded to the phenyl group via an oxygen atom and does not include an oxygen atom (-O-) forming an ether bond within the alkoxy group. This is the same even in a case where the alkyl group may be further substituted with a group selected from the substituent group T which will be described later.

Examples of the alkoxy group include a linear alkoxy group, a branched alkoxy group, and a cyclic (cyclo)alkoxy group. The alkyl moiety of the alkoxy group has the same definition as for the alkyl group, and preferred examples thereof are also the same.

Examples of the linear alkoxy group or branched alkoxy group include methoxy, ethoxy, n-propoxy, i-propoxy, n-butoxy, t-butoxy, 2,2-dimethylpropoxy, n-pentoxy, n-hexyloxy, cyclohexyloxy, n-octyloxy, 2-ethylhexyloxy, 2-butyloctyloxy, 3,7-dimethyloctyloxy, n-decyloxy, isodecyloxy, s-decyloxy, 2-butyloctyloxy, n-dodecyloxy, n-hexadecyloxy, isohexadecyloxy, n-eicosyloxy, n-hexacosyloxy, and isooctacosyloxy.

Examples of the cyclic alkoxy include cyclopropyloxy, cyclopentyloxy, cyclohexyloxy, cycloheptyloxy, and cyclooctyloxy.

The alkoxy group may be further substituted with a group selected from the substituent group T will be described later, but is not substituted with a group bonded to an oxygen atom (an alkoxy group, an aryloxy group, or the like).

Examples of the aryloxy group which can be contained in the phenyl group of each of Ar¹¹ to Ar¹⁴ include a hydrocarbon ring-based aryloxy group in which an aryl group is an aromatic hydrocarbon ring, and a heteroaryloxy group in which an aryl group is an aromatic heterocyclic group. The number of carbon atoms in the aryloxy group is preferably 3 to 30, more preferably 3 to 25, still more preferably 3 to 20, and particularly preferably 3 to 16. Examples of the aryloxy group include phenoxy, naphthoxy, imidazolyloxy, benzimidazolyloxy, pyridin-4-yloxy, pyrimidinyloxy, quinazolinyloxy, purinyloxy, and thiophen-3-yloxy. As the heterocycle of the heteroaryloxy group, a thiophene ring is preferable.

The aryloxy group may be further substituted with a group selected from the substituent group T will be described later.

Examples of the alkylthio group which can be contained in the phenyl group of each of Ar¹¹ to Ar¹⁴ include a linear alkylthio group, a branched alkylthio group, and a cyclic (cyclo)alkylthio group. The alkyl moiety of the alkylthio group has the same definition as for the alkyl group, and preferred examples thereof are also the same.

Examples of the linear alkylthio group or branched alkylthio group include methylthio, ethylthio, n-propylthio, i-propylthio, n-butylthio, t-butylthio, 2,2-dimethylpropylthio, n-pentylthio, n-hexylthio, cyclohexylthio, n-octylthio, 2-ethylhexylthio, 3,7-dimethyloctylthio, n-decylthio, isodecylthio, s-decylthio, n-dodecylthio, 2-butyloctylthio, n-hexadecylthio, isohexadecylthio, n-eicosylthio, n-hexacosylthio, and isooctacosylthio.

Examples of the cyclic alkylthio group include cyclopropylthio, cyclopentylthio, cyclohexylthio, cycloheptylthio, and cyclooctylthio.

The alkylthio group may be further substituted with a group selected from the substituent group T will be described later.

Examples of the arylthio group which can be contained in the phenyl group of each of Ar¹¹ to Ar¹⁴ include a hydrocarbon ring-based arylthio group in which an aryl group is an aromatic hydrocarbon ring, and a heteroarylthio group in which an aryl group is an aromatic heterocyclic group. The number of carbon atoms in the arylthio group is preferably 3 to 30, more preferably 3 to 25, still more preferably 3 to 20, and particularly preferably 3 to 16. Examples of the arylthio group include phenylthio, naphthylthio, imidazolylthio, benzimidazolylthio, pyridin-4-ylthio, pyrimidinylthio, quinazolinylthio, purinylthio, and thiophen-3-ylthio. As the heterocycle of the heteroarylthio group, a thiophene ring is preferable.

The arylthio group may be further substituted with a group selected from the substituent group T will be described later.

Examples of the halogen atom which can be contained in the phenyl group of each of Ar¹¹ to Ar¹⁴, and the halogen atom which can be adopted as each of R²¹ and R²² include a fluorine atom, a chlorine atom, a bromine atom, and an iodine atom. Among these, a fluorine atom or a chlorine atom is preferable, and a fluorine atom is more preferable.

R¹¹ and R¹² each represent an alkyl group, an alkoxy group, an aryl group, an alkylthio group, a heteroaryl group, an amino group, or a halogen atom. Among these, an alkyl group, an alkoxy group, an aryl group, or a halogen atom is preferable, and an alkyl group or an aryl group is more preferable.

Examples of these groups which can be adopted as R¹¹ and R¹² include the correspondent groups in the substituent group T which will be described later, and preferred examples thereof are also the same.

n¹¹ and n¹² each represent an integer of 0 to 3, and is preferably 0 or 1, and more preferably 0.

R¹³ and R¹⁴ each represent an alkyl group, an alkoxy group, an aryl group, an alkylthio group, a heteroaryl group, an amino group, or a halogen atom. Among these, an alkyl group, an alkoxy group, an aryl group, or a halogen atom is preferable, and an alkyl group or an aryl group is more preferable.

Examples of these groups which can be adopted as R¹³ and R¹⁴ include the correspondent groups in the substituent group T which will be described later, and preferred examples thereof are also the same.

n¹³ and n¹⁴ each represent an integer of 0 to 4, and is preferably an integer of 0 to 2, and more preferably 0 or 1.

L³ and L⁴ may be each a monodentate ligand, and are each preferably, for example, a group or atom selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a cyano group, an alkylthio group, an arylthio group, an alkoxy group, an aryloxy group, and a halogen atom, or anions thereof.

In a case where the ligands L³ and L⁴ each include an alkyl group, an alkenyl group, an alkynyl group, an alkylene group, or the like, these may be linear, branched, or cyclic, and may or may not have a substituent. Further, in a case where a group capable of adopting a cyclic structure, such as an aryl group, a heterocyclic group, and a cycloalkyl group, is included, these may or may not have a substituent, and may be a monocycle or be fused to form a ring.

Among those, the ligands L³ and L⁴ are each preferably a cyanate group, an isocyanate group, a thiocyanate group, or an isothiocyanate group, or an anion thereof, more preferably an isocyanate group (isocyanate anion) or an isothiocyanate group (isothiocyanate anion), and particularly preferably an isothiocyanate group (isothiocyanate anion).

M¹ and M² each represent any one of a proton, a metal cation, and a non-metal cation. M¹ and M² are each preferably a non-metal cation from the viewpoints of improvement of the photoelectric conversion efficiency and reduction in the deviation, and preferably a proton or a metal cation from the viewpoint of durability.

The metal cation which can be adopted as each of M¹ and M² is not particularly limited, but examples thereof include an alkali metal ion, an alkaline earth metal ion, and a metal complex ion. Among these, an alkali metal ion or an alkaline earth metal ion is preferable, an alkali metal ion is more preferable, a lithium ion, a sodium ion, or a potassium ion is still more preferably, and a sodium ion or a potassium ion is particularly preferable.

The non-metal cation which can be adopted as each of M¹ and M² is not particularly limited, but examples thereof include inorganic or organic ammonium ions (for example, tetraalkylammonium ions such as tetrabutylammonium, triethylbenzylammonium), a phosphonium ion (for example, tetraalkylphosphonium ions such as a tetrabutylphosphonium ion and alkyltriphenylphosphonium ions), a pyridinium ion, an imidazolium ion, an amidinium ion, and a guanidinium ion. Among these, organic ammonium ions (a tetraethylammonium ion, a tetrabutylammonium ion, a tetrahexylammonium ion, a tetraoctylammonium ion, a tetradecylammonium ion, a tetradodecylammonium ion, and the like), a pyridinium ion, an imidazolium ion, or an amidinium ion is preferable, an organic ammonium ion, a pyridinium ion, or an imidazolium ion is more preferable, and organic ammonium ions are still more preferable.

The metal complex dye represented by Formula (1) can be synthesized by, for example, the methods described in JP2001-291534A, JP2013-072079A, JP2008-021496A, and J. Mater. Chem., 2009, 19, p. 5364-5376, the patent documents regarding solar cells, known methods, or the methods equivalent thereto.

The metal complex dye represented by Formula (1) has a maximum absorption wavelength in a solution, preferably in a range from 300 to 1,000 nm, more preferably in a range from 350 to 950 nm, and particularly preferably in a range from 370 to 900 nm.

### <Substituent Group T>

In the present invention, preferred examples of the substituent include the groups selected from the following substituent group T.

Incidentally, in the present specification, a case where there is only a simple description of a substituent is intended to refer to this substituent group T, and further, in a case where each of the groups, for example, an alkyl group is merely described, a preferable range and specific examples for the corresponding group for the substituent group T are applied.

Moreover, in the present specification, in a case where an alkyl group is described as different from a cyclic (cyclo)alkyl group, the alkyl group is used to mean inclusion of both of a linear alkyl group and a branched alkyl group. On the other hand, in a case where an alkyl group is not described as different from a cycloalkyl group (a case where an alkyl group is simply described), and unless otherwise specified, the alkyl group is used to mean any of a linear alkyl group, a branched alkyl group, and a cycloalkyl group. This shall apply to a group (an alkoxy group, an alkylthio group, an alkenyloxy group, and the like) including a group (an alkyl group, an alkenyl group, an alkynyl group, and the like) which can adopt a cyclic structure, and a compound including a group which can adopt a cyclic structure. In the following description of the substituent group, for example, a group with a linear or branched structure and a group with a cyclic structure may be sometimes separately described for clarification of both groups, as in the alkyl group and the cycloalkyl group.

Examples of the groups included in the substituent group T include the following groups, or groups formed by combination of a plurality of the following groups:
an alkyl group (preferably an alkyl group having 1 to 20 carbon atoms, and more preferably an alkyl group having 1 to 12 carbon atoms, for example, methyl, ethyl, isopropyl, t-butyl, pentyl, heptyl, 1-ethylpentyl, benzyl, 2-ethoxyethyl, 1-carboxymethyl, and trifluoromethyl), an alkenyl group (preferably an alkenyl group having 2 to 20 carbon atoms, and more preferably an alkenyl group having 1 to 12 carbon atoms, for example, vinyl, allyl, and oleyl), an alkynyl group (preferably an alkynyl group having 2 to 20 carbon atoms, and preferably an alkynyl group having 1 to 12 carbon atoms, for example, ethynyl, butynyl, and phenylethynyl), a cycloalkyl group (preferably a cycloalkyl group having 3 to 20 carbon atoms), an cycloalkenyl group (preferably a cycloalkenyl group having 5 to 20 carbon atoms), an aryl group (preferably an aryl group having 6 to 26 carbon atoms, for example, phenyl, 1-naphthyl, 4-methoxyphenyl, 2-chlorophenyl, 3-methylphenyl, difluorophenyl, and tetrafluorophenyl), a heterocyclic group (preferably a heterocyclic group having 2 to 20 carbon atoms, more preferably a 5- or 6-membered heterocyclic group having at least one oxygen atom, sulfur atom, or nitrogen atom; and examples of the heterocycle include an aromatic ring and an aliphatic ring. Examples of the aromatic heterocyclic group (for example, a heteroaryl group) include the following groups. For example, 2-pyridyl, 4-pyridyl, 2-imidazolyl, 2-benzimidazolyl, 2-thiazolyl, and 2-oxazolyl), an alkoxy group (preferably an alkoxy group having 1 to 20 carbon atoms, and more preferably an alkoxy group having 1 to 12 carbon atoms, for example, methoxy, ethoxy, isopropyloxy, and benzyloxy), an alkenyloxy group (preferably an alkenyloxy group having 2 to 20 carbon atoms, and more preferably an alkenyloxy group having 1 to 12 carbon atoms), an alkynyloxy group (preferably an alkynyloxy group having 2 to 20 carbon atoms, and more preferably an alkynyloxy group having 1 to 12 carbon atoms), a cycloalkyloxy group (preferably a cycloalkyloxy group having 3 to 20 carbon atoms), an aryloxy group (preferably an aryloxy group having 6 to 26 carbon atoms), a heterocyclic oxy group (preferably a heterocyclic oxy group having 2 to 20 carbon atoms),
an alkoxycarbonyl group (preferably an alkoxycarbonyl group having 2 to 20 carbon atoms), a cycloalkoxycarbonyl group (preferably a cycloalkoxycarbonyl group having 4 to 20 carbon atoms), an aryloxycarbonyl group (preferably an aryloxycarbonyl group having 6 to 20 carbon atoms), an amino group (preferably an amino group having 0 to 20 carbon atoms including an alkylamino group, an alkenylamino group, an alkynylamino group, a cycloalkylamino group, a cycloalkenylamino group, an arylamino group, and a heterocyclic amino group, for example, amino, N,N-dimethylamino, N,N-diethylamino, N-ethylamino, N-allylamino, N-(2-propynyl)amino, N-cyclohexylamino, N-cyclohexenylamino, anilino, pyridylamino, imidazolylamino, benzimidazolylamino, thiazolylamino, benzothiazolylamino, and triazinylamino), a sulfamoyl group (preferably a sulfamoyl group having 0 to 20 carbon atoms, preferably an alkyl-, cycloalkyl-, or aryl-sulfamoyl group), an acyl group (preferably an acyl group having 1 to 20 carbon atoms), an acyloxy group (preferably an acyloxy group having 1 to 20 carbon atoms), a carbamoyl group (preferably a carbamoyl group having 1 to 20 carbon atoms, preferably an alkyl-, cycloalkyl-, or aryl-carbamoyl group),
an acylamino group (preferably an acylamino group having 1 to 20 carbon atoms), a sulfonamido group (preferably a sulfonamido group having 0 to 20 carbon atoms, and preferably an alkyl-, cycloalkyl-, or aryl-sulfonamido group), an alkylthio group (preferably an alkylthio group having 1 to 20 carbon atoms, and more preferably an alkylthio group having 1 to 12 carbon atoms, for example, methylthio, ethylthio, isopropylthio, and benzylthio), a cycloalkylthio group (preferably a cycloalkylthio group having 3 to 20 carbon atoms), an arylthio group (preferably an arylthio group having 6 to 26 carbon atoms), an alkyl-, cycloalkyl-, or aryl-sulfonyl group (preferably an alkyl-, cycloalkyl-, or aryl-sulfonyl group having 1 to 20 carbon atoms),
a silyl group (preferably a silyl group having 1 to 20 carbon atoms, preferably an alkyl-, aryl-, alkoxy-, and aryloxy-substituted silyl group), a silyloxy group (preferably a silyloxy group having 1 to 20 carbon atoms, preferably an alkyl-, aryl-, alkoxy-, and aryloxy-substituted silyloxy group), a hydroxyl group, a cyano group, a nitro group, a halogen atom (for example, a fluorine atom, a chlorine atom, a bromine atom, and iodine atom), a carboxyl group, a sulfo group, a phosphonyl group, a phosphoryl group, and a boric acid group.

Examples of the group selected from the substituent group T more preferably include an alkyl group, an alkenyl group, a cycloalkyl group, an aryl group, a heterocyclic group, an alkoxy group, a cycloalkoxy group, an aryloxy group, an alkoxycarbonyl group, a cycloalkoxycarbonyl group, an amino group, an acylamino group, a cyano group, and a halogen atom; and particularly preferably include an alkyl group, an alkenyl group, a heterocyclic group, an alkoxy group, an alkoxycarbonyl group, an amino group, an acylamino group, and a cyano group.

In a case where the compound, the substituent, or the like includes an alkyl group, an alkenyl group, or the like, these may be substituted or unsubstituted. Further, in a case where the compound, the substituent, or the like includes an aryl group, a heterocyclic group, or the like, these may be a monocycle or a fused ring, and may be substituted or unsubstituted.

Specific examples of the metal complex dye represented by Formula (1) are shown below and in Examples, but the present invention is not limited to these metal complex dyes. In a case where these metal complex dyes are present as have optical isomers or geometric isomers, the metal complex dye may be any of these isomers or a mixture of these isomers. In a case where in the following specific examples, any one of M¹ and M² is a metal cation or a non-metal cation, for the sake of convenience, M¹ is described as the metal cation or the non-metal cation. The present invention is not limited to such a case, M² may be a metal cation or a non-metal cation, and a mixture of M¹ being a metal cation or a non-metal cation and M² of a metal cation or a non-metal cation may also be available (the mixing ratio is not particularly limited).

In the following specific examples, * of D¹ and D² represents a bonding position to a double bond (vinyl group) in Formula (3).

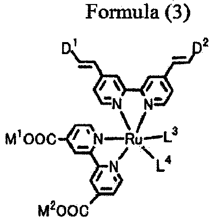

| Ligand No. | M¹ | M² | L³ | L⁴ | D¹ | D² |
|---|---|---|---|---|---|---|
| LA-1 | H | H | -NCS | -NCS | 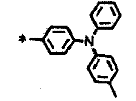 | 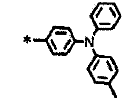 |
| LA-2 | H | H | -NCS | -NCS | 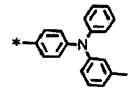 | 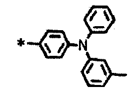 |
| LA-3 | H | H | -NCS | -NCS | 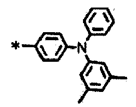 | 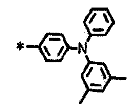 |
| LA-4 | H | H | -NCS | -NCS | 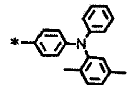 | 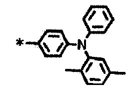 |
| LA-5 | H | H | -NCS | -NCS | 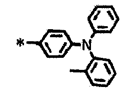 | 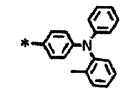 |
| LA-6 | H | H | -NCS | -NCS | 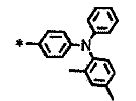 | 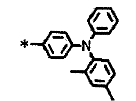 |
| LA-7 | H | H | -NCS | -NCS | 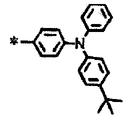 | 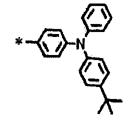 |
| LA-8 | H | H | -NCS | -NCS | 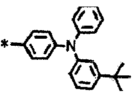 | 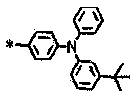 |
| LA-9 | H | H | -NCS | -NCS | 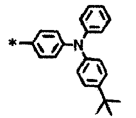 | 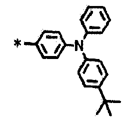 |

| Ligand No. | M¹ | M² | L³ | L⁴ | D¹ | D² |
|---|---|---|---|---|---|---|
| LA-10 | H | H | -NCS | -NCS | 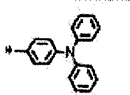 | 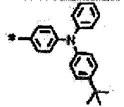 |
| LA-11 | H | H | -NCS | -NCS | 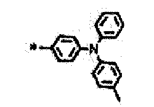 | 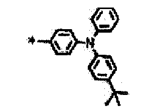 |
| LA-12 | H | H | -NCS | -NCS | 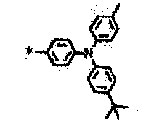 | 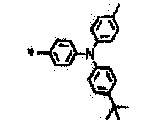 |
| LA-13 | H | H | -NCS | -NCS | 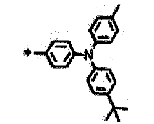 | 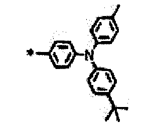 |
| LA-14 | H | H | -NCS | -NCS | 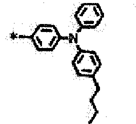 | 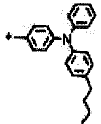 |
| LA-15 | H | H | -NCS | -NCS | 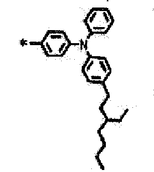 | 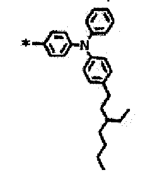 |
| LA-16 | H | H | -NCS | -NCS | 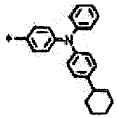 | 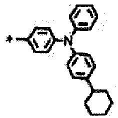 |
| LA-17 | H | H | -NCS | -NCS | 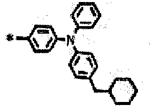 | 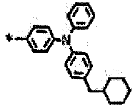 |
| LA-18 | H | H | -NCS | -NCS | 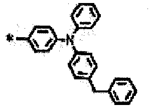 | 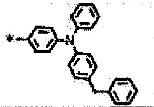 |

| Ligand No. | M¹ | M² | L³ | L⁴ | D¹ | D² |
|---|---|---|---|---|---|---|
| LA-19 | H | H | -NCS | -NCS | 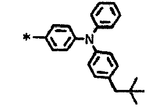 | 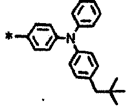 |
| LA-20 | H | H | -NCS | -NCS | 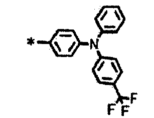 | 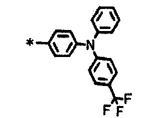 |
| LA-21 | H | H | -NCS | -NCS | 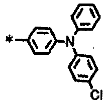 | 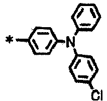 |
| LA-22 | H | H | -NCS | -NCS | 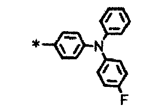 | 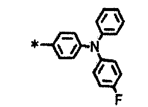 |
| LA-23 | H | H | -NCS | -NCS | 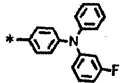 | 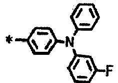 |
| LA-24 | H | H | -NCS | -NCS | 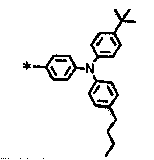 | 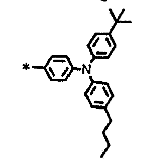 |
| LA-25 | H | H | -NCS | -NCS | 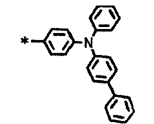 | 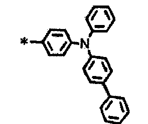 |
| LA-26 | H | H | -NCS | -NCS | 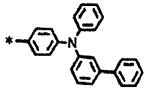 | 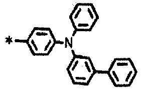 |
| LA-27 | H | H | -NCS | -NCS | 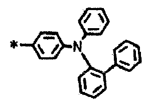 | 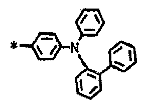 |

| Ligand No. | M¹ | M² | L³ | L⁴ | D¹ | D² |
|---|---|---|---|---|---|---|
| LA-28 | H | H | -NCS | -NCS | 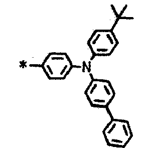 | 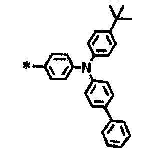 |
| LA-29 | H | H | -NCS | -NCS | 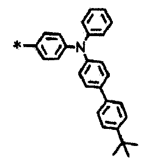 | 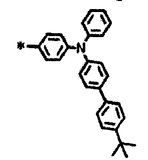 |
| LA-30 | H | H | -NCS | -NCS | 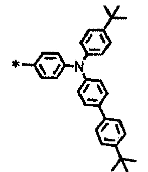 | 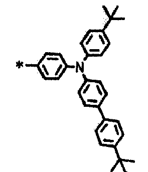 |
| LA-31 | H | H | -NCS | -NCS | 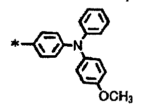 | 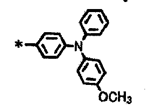 |
| LA-32 | H | H | -NCS | -NCS | 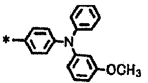 | 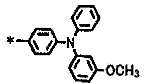 |
| LA-33 | H | H | -NCS | -NCS | 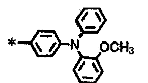 | 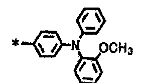 |
| LA-34 | H | H | -NCS | -NCS | 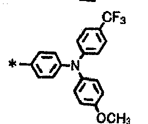 | 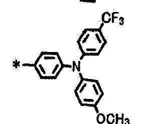 |
| LA-35 | H | H | -NCS | -NCS | 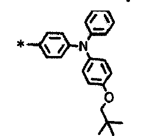 | 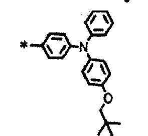 |

| Ligand No. | M¹ | M² | L³ | L⁴ | D¹ | D² |
|---|---|---|---|---|---|---|
| LA-36 | H | H | -NCS | -NCS | 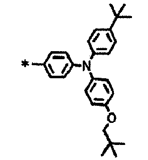 | 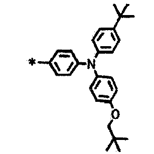 |
| LA-37 | H | H | -NCS | -NCS | 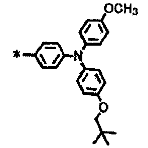 | 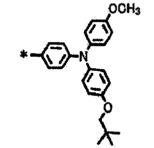 |
| LA-38 | H | H | -NCS | -NCS | 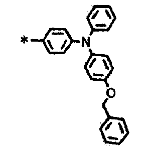 | 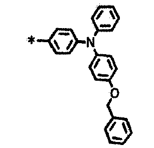 |
| LA-39 | H | H | -NCS | -NCS | 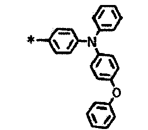 | 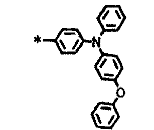 |
| LA-40 | H | H | -NCS | -NCS | 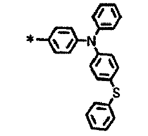 | 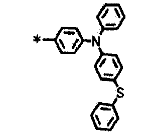 |
| LA-41 | H | H | -NCS | -NCS | 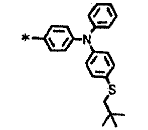 | 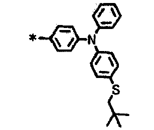 |
| LA-42 | H | H | -NCS | -NCS | 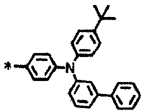 | 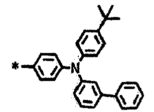 |
| LA-43 | H | H | -NCS | -NCS | 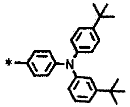 | 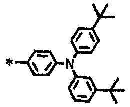 |

| Ligand No. | M¹ | M² | L³ | L⁴ | D¹ | D² |
|---|---|---|---|---|---|---|
| LA-44 | H | H | -NCS | -NCS | 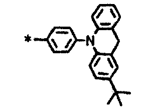 | 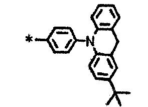 |
| LA-45 | H | H | -NCS | -NCS | 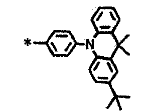 | 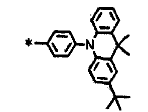 |
| LA-46 | H | H | -NCS | -NCS | 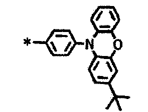 | 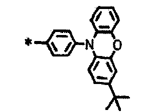 |
| LA-47 | H | H | -NCS | -NCS | 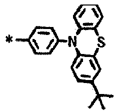 | 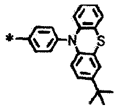 |
| LA-48 | H | H | -NCS | -NCS | 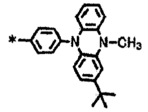 | 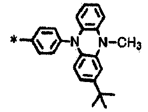 |
| LA-49 | H | H | -NCS | -NCS | 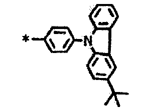 | 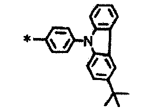 |
| LA-50 | H | H | -NCS | -NCS | 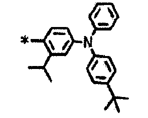 | 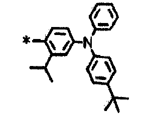 |
| LA-61 | H | H | -NCS | -NCS | 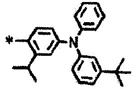 | 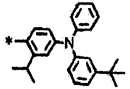 |
| LA-52 | H | H | -NCS | -NCS | 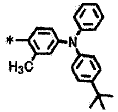 | 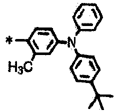 |
| LA-53 | H | H | -NCS | -NCS | 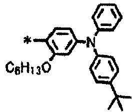 | 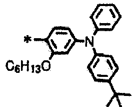 |

| Ligand No. | M¹ | M² | L³ | L⁴ | D¹ | D² |
|---|---|---|---|---|---|---|
| LA-54 | Na | H | -NCS | -NCS | 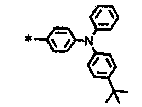 | 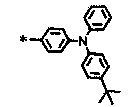 |
| LA-55 | K | H | -NCS | -NCS | 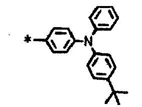 | 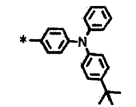 |
| LA-56 | 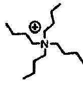 | H | -NCS | -NCS | 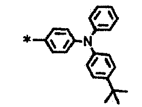 | 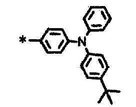 |
| LA-57 | 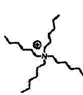 | H | -NCS | -NCS | 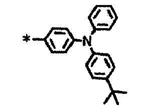 | 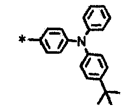 |
| LA-58 | Na | H | -NCS | -NCS | 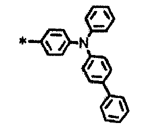 | 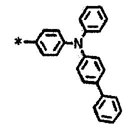 |
| LA-59 | K | H | -NCS | -NCS | 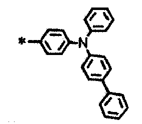 | 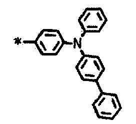 |
| LA-60 | 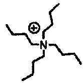 | H | -NCS | -NCS | 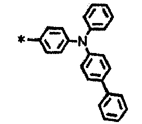 | 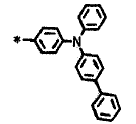 |
| LA-61 | 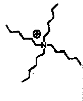 | H | -NCS | -NCS | 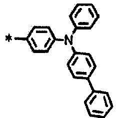 | 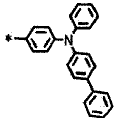 |

Next, preferred aspects of the main members of the photoelectric conversion element and the dye-sensitized solar cell will be described.

### <Electrically Conductive Support>

The electrically conductive support is not particularly limited as long as it has electrical conductivity and is capable of supporting a photoconductor layer 2 or the like. The electrically conductive support is a material having conductivity, for example, preferably an electrically conductive support 1 formed of a metal, or an electrically conductive support 41 having a glass or plastic substrate 44 and a transparent electrically-conductive film 43 formed on the surface of the substrate 44.

Between them, the electrically conductive support 41 having the transparent electrically-conductive film 43 of a metal oxide on the surface of the substrate 44 is more preferable. Such the electrically conductive support 41 is obtained by applying an electrically conductive metal oxide on the surface of the substrate 44 to form the transparent electrically-conductive film 43. Examples of the substrate 44 formed of plastics include the transparent polymer films described in paragraph No. 0153 of JP2001-291534A. Further, as a material which forms the substrate 44, ceramics (JP2005-135902A) or electrically conductive resins (JP2001-160425A) can be used, in addition to glass and plastics. As the metal oxide, tin oxide (TO) is preferable, and indium-tin oxide (tin-doped indium oxide; ITO), and fluorine-doped tin oxide such as tin oxide which has been doped with tin (FTO) are particularly preferable. In this case, the coating amount of the metal oxide is preferably 0.1 to 100 g, per square meter of the surface area of the substrate 44. In a case of using the electrically conductive support 41, it is preferable that light is incident from the substrate 44.

It is preferable that the electrically conductive supports 1 and 41 are substantially transparent. The expression, "substantially transparent", means that the transmittance of light (at a wavelength of 300 to 1,200 nm) is 10% or more, preferably 50% or more, and particularly preferably 80% or more.

The thickness of the electrically conductive supports 1 and 41 is not particularly limited, but is preferably 0.05 µm to 10 mm, more preferably 0.1 µm to 5 mm, and particularly preferably 0.3 µm to 4 mm.

In a case of including the transparent electrically-conductive film 43, the thickness of the transparent electrically-conductive film 43 is preferably 0.01 to 30 µm, more preferably 0.03 to 25 µm, and particularly preferably 0.05 to 20 µm.

It is preferable that the electrically conductive supports 1 and 41 have a metal oxide coating film including a metal oxide on the surface thereof. As the metal oxide, the metal oxide that forms the transparent electrically-conductive film 43 or the metal oxide mentioned as the metal oxide as the semiconductor fine particles which will be described later can be used, with the metal oxide mentioned as the semiconductor fine particles being preferable. The metal oxide may be the same as or different from the metal oxide that forms the transparent electrically-conductive film 43 or the metal oxide mentioned as the semi-conductive fine particles. The metal oxide coating film is usually formed on a thin film, and preferably has a thickness of 0.01 to 100 nm, for example. A method for forming the metal oxide coating film is not particularly limited, and examples thereof include the same method as the method for forming a layer formed by the semiconductor fine particles, which will be described later. For example, a liquid including a metal oxide or a precursor thereof (for example, a halide and an alkoxide) can be applied and heated (calcined) to form a metal oxide coating film.

The electrically conductive supports 1 and 41 may be provided with a light management function at the surface, and may have, for example, the anti-reflection film having a high refractive index film and a low refractive index oxide film alternately laminated described in JP2003-123859A, and the light guide function described in JP2002-260746A on the surface.

### <Photoconductor Layer>

As long as the photoconductor layer has semiconductor fine particles 22 carrying the dye 21 and an electrolyte, it is not particularly limited in terms of other configurations. Preferred examples thereof include the photoconductor layer 2 and the photoconductor layer 42.

### - Semiconductor Fine Particles (Layer Formed by Semiconductor Fine Particles) -

The semiconductor fine particles 22 are preferably fine particles of chalcogenides of metals (for example, oxides, sulfides, and selenides) or of compounds having perovskite type crystal structures. Preferred examples of the chalcogenides of metals include oxides of titanium, tin, zinc, tungsten, zirconium, hafnium, strontium, indium, cerium, yttrium, lanthanum, vanadium, niobium, or tantalum, cadmium sulfide, and cadmium selenide. Preferred examples of the compounds having perovskite type crystal structures include strontium titanate and calcium titanate. Among these, titanium oxide (titania), zinc oxide, tin oxide, and tungsten oxide are particularly preferable.

Examples of the crystal structure of titania include structures of an anatase type, a brookite type, and a rutile type, with the structures of an anatase type and a brookite type being preferable. A titania nanotube, nanowire, or nanorod may be used singly or in mixture with titania fine particles.

The particle diameter of the semiconductor fine particles 22 is expressed in terms of an average particle diameter using a diameter in a case where a projected area is converted into a circle, and is preferably 0.001 to 1 µm as primary particles, and 0.01 to 100 µm as an average particle diameter of dispersions. Examples of the method for coating the semiconductor fine particles 22 on the electrically conductive supports 1 or 41 include a wet method, a dry method, and other methods.

It is preferable that the semiconductor fine particles 22 have a large surface area so that they may adsorb a large amount of the dye 21. For example, in a state where the semiconductor fine particles 22 are coated on the electrically conductive support 1 or 41, the surface area is preferably 10 times or more, and more preferably 100 times or more, with respect to the projected surface area. The upper limit of this value is not particularly limited, and the upper limit is usually approximately 5,000 times. In general, as the thickness of the layer (photoconductor layer) formed by the semiconductor fine particles increases, the amount of dye 21 that can be carried per unit area increases, and therefore, the light absorption efficiency increases. However, since the diffusion distance of generated electrons increases correspondingly, the loss due to charge recombination also increases.

Although a preferred thickness of the layer formed by the semiconductor fine particles may vary depending on the utility of the photoelectric conversion element, it is typically 0.1 to 100 µm. In a case of using the photoelectric conversion element as a dye-sensitized solar cell, the thickness of the photoconductor layer is more preferably 1 to 50 µm, and still more preferably 3 to 30 µm.

It is preferable that the semiconductor fine particles 22 may be calcined at a temperature of 100°C to 800°C for 10 minutes to 10 hours after being applied on the electrically conductive support 1 or 41, so as to bring about cohesion of the particles. In a case of using glass as a material for the electrically conductive support 1 or the substrate 44 is used, the film-forming temperature is preferably 60°C to 600°C.

The coating amount of the semiconductor fine particles 22 per square meter of the surface area of the electrically conductive support 1 or 41 is preferably 0.5 to 500 g, and more preferably 5 to 100 g.

It is preferable that a short circuit-preventing layer is formed between the electrically conductive support 1 or 41 and the photoconductor layer 2 or 42 so as to prevent reverse current due to a direct contact between the electrolyte included in the photoconductor layer 2 or 42 and the electrically conductive support 1 or 41.

In addition, it is preferable to employ a spacer S (see Fig. 2) or a separator, so as to prevent contact between the light-receiving electrode 5 or 40 and the counter electrode 4 or 48.

### - Light-Scattering Layer -

In the present invention, the light-scattering layer is different from the semiconductor layer in that the light-scattering layer has a function of scattering incident light.

In the dye-sensitized solar cell 20, the light-scattering layer 46 preferably contains rod-shaped or plate-shaped metal oxide particles. Examples of the metal oxide particles to be used in the light-scattering layer 46 include particles of the chalcogenides (oxides) of the metals, described above as the compound which forms semiconductor fine particles. In a case of providing the light-scattering layer 46, it is preferable that the thickness of the light-scattering layer is set to 10% to 50% of the thickness of the photoconductor layer.

The light-scattering layer 46 is preferably the light-scattering layer described in JP2002-289274A, and the description of JP2002-289274A is preferably herein incorporated by reference.

### - Metal Oxide Layer Coating Film -

In the present invention, semiconductor fine particles which form a photoconductor layer (including a case of forming the semiconductor layer 45 and the light-scattering layer 46), and preferably have a metal oxide coating film on the surface thereof. As the metal oxide which forms a metal oxide coating film, the metal oxide mentioned as the semiconductor fine particles can be used, and the metal oxide may be the same as or different from the semiconductor fine particles. This metal oxide coating film is usually formed on a thin film, and preferably has a thickness of 0.1 to 100 nm, for example. In the present invention, in a case where the semiconductor fine particles have a metal oxide coating film, the metal complex dye is adsorbed on the semiconductor fine particles via the metal oxide coating film. A method for forming the metal oxide coating film is as described above.

In the present invention, in particular, it is preferable that the surfaces of the electrically conductive support and the semiconductor fine particles each have the metal oxide coating film. In this case, each of the metal oxide coating films may be formed of the same or different kinds of metal oxides.

### - Dye -

In the photoelectric conversion element 10 and the dye-sensitized solar cell 20, at least one kind of metal complex dye represented by Formula (1) is used as a sensitizing dye. The metal complex dye represented by Formula (1) is as described above.

In the present invention, examples of the dye that can be used in combination with the metal complex dye of Formula (1) include an Ru complex dye, a squarylium cyanine dye, an organic dye, a porphyrin dye, and a phthalocyanine dye. As the dye which can be used with the other, an Ru complex dye, a squarylium cyanine dye, or an organic dye is preferable.

The overall amount of the dye to be used is preferably 0.01 to 100 millimoles, more preferably 0.1 to 50 millimoles, and particularly preferably 0.1 to 10 millimoles, per square meter of the surface area of the electrically conductive support 1 or 41. Further, the amount of the dye to be adsorbed onto the semiconductor fine particles is preferably 0.001 to 1 millimole, and more preferably 0.1 to 0.5 millimoles, with respect to 1 g of the semiconductor fine particles. By setting the amount of the dye to such a range, the sensitization effect on the semiconductor fine particles is sufficiently obtained.

In a case where the metal complex dye represented by Formula (1) is used in combination with another dye, the ratio of the mass of the metal complex dye represented by Formula (1)/the mass of another dye is preferably 95/5 to 10/90, more preferably 95/5 to 50/50, still more preferably 95/5 to 60/40, particularly preferably 95/5 to 65/35, and most preferably 95/5 to 70/30.

After the dye is carried on the semiconductor fine particles, the surface of the semiconductor fine particles may be treated using an amine compound. Preferred examples of the amine compound include pyridine compounds (for example, 4-t-butylpyridine and polyvinylpyridine). These may be used as they are in a case where they are liquids, or may be used in a state where they are dissolved in an organic solvent.

### - Co-Adsorbent -

In the present invention, it is preferable to use a co-adsorbent together with the metal complex dye represented by Formula (1) or with another dye to be used in combination, if necessary. Such a co-adsorbent which includes a co-adsorbent having at least one acidic group (preferably a carboxyl group or a salt thereof) is preferable, and examples thereof include a fatty acid and a compound having a steroid skeleton.

The fatty acid may be a saturated fatty acid or an unsaturated fatty acid, and examples thereof include a butanoic acid, a hexanoic acid, an octanoic acid, a decanoic acid, a hexadecanoic acid, a dodecanoic acid, a palmitic acid, a stearic acid, an oleic acid, a linoleic acid, and a linolenic acid.

Examples of the compound having a steroid skeleton include cholic acid, glycocholic acid, chenodeoxycholic acid, hyocholic acid, deoxycholic acid, lithocholic acid, and ursodeoxycholic acid, among which cholic acid, deoxycholic acid, and chenodeoxycholic acid are preferable; and deoxycholic acid and chenodeoxycholic acid are more preferable.

Preferred examples of the co-adsorbents include the compounds represented by Formula (CA) described in paragraph Nos. 0125 to 0129 of JP2014-82187A, and the description of paragraph Nos. 0125 to 0129 of JP2014-82187A are preferably incorporated herein.

By making the co-adsorbent adsorbed onto the semiconductor fine particles, the co-adsorbent exhibits an effect of suppressing the inefficient association of the metal complex dye and an effect of preventing reverse electron transfer from the surface of the semiconductor fine particles to the redox system in the electrolyte. The amount of the co-adsorbent to be used is not particularly limited, and from the viewpoint of exhibiting the above effects effectively, the amount is preferably 1 to 200 moles, more preferably 10 to 150 moles, and particularly preferably 20 to 50 moles, with respect to 1 mole of the metal complex dye.

### <Charge Transfer Layer>

The charge transfer layers 3 and 47 used in the photoelectric conversion element of the present invention are layers having a function of complementing electrons for the oxidized forms of the dye 21, and are provided between the light-receiving electrode 5 or 40 and the counter electrode 4 or 48.

The charge transfer layers 3 and 47 include electrolytes. Here, the expression, "the charge transfer layer includes an electrolyte", is meant to encompass both of an aspect in which the charge transfer layer consists of only electrolytes and an aspect in which the charge transfer layer consists of electrolytes and materials other than the electrolytes.

The charge transfer layers 3 and 47 may be any of a solid form, a liquid form, a gel form, or a mixture thereof.

### - Electrolyte -

Examples of the electrolyte include a liquid electrolyte having a redox pair dissolved in an organic solvent, and a so-called gel electrolyte in which a molten salt containing a redox pair and a liquid having a redox pair dissolved in an organic solvent are impregnated in a polymer matrix. Among those, from the viewpoint of photoelectric conversion efficiency, a liquid electrolyte is preferable.

Examples of the redox pair include a combination of iodine and an iodide (preferably an iodide salt or an iodide ionic liquid, and more preferably lithium iodide, tetrabutylammonium iodide, tetrapropylammonium iodide, and methylpropylimidazolium iodide), a combination of an alkylviologen (for example, methylviologen chloride, hexylviologen bromide, and benzylviologen tetrafluoroborate) and a reductant thereof, a combination of a polyhydroxybenzene (for example, hydroquinone and naphthohydroquinone) and an oxidized form thereof, a combination of a divalent iron complex and a trivalent iron complex (for example, a combination of potassium ferricyanide and potassium ferrocyanide), and a combination of a divalent cobalt complex and a trivalent cobalt complex. Among these, a combination of iodine and an iodide, or a combination of a divalent cobalt complex and a trivalent cobalt complex is preferable, and a combination of iodine and an iodide is particularly preferable.

As the cobalt complex, the complex represented by Formula (CC) described in paragraph Nos. 0144 to 0156 of JP2014-82189A is preferable, and the description of paragraph Nos. 0144 to 0156 of JP2014-82189A is preferably incorporated in the present specification.

In a case where a combination of iodine and iodide is used as an electrolyte, it is preferable that a nitrogen-containing aromatic cation iodide salt of a 5- or 6-membered ring is additionally used.

The organic solvent which is used in a liquid electrolyte and a gel electrolyte is not particularly limited, but is preferably an aprotic polar solvent (for example, acetonitrile, propylene carbonate, ethylene carbonate, dimethylformamide, dimethylsulfoxide, sulfolane, 1,3-dimethylimidazolinone, and 3-methyloxazolidinone).

In particular, as the organic solvent which is used for a liquid electrolyte, a nitrile compound, an ether compound, an ester compound, or the like is preferable, a nitrile compound is more preferable, and acetonitrile or methoxypropionitrile is particularly preferable.

As a molten salt or a gel electrolyte, those described in paragraph No. 0205 and paragraph Nos. 0208 to 0213 of JP2014-139931A are preferable, and those described in paragraph No. 0205 and paragraph Nos. 0208 to 0213 of JP2014-139931A are preferably incorporated herein.

The electrolyte may contain aminopyridine compounds, benzimidazole compounds, aminotriazole compounds, aminothiazole compounds, imidazole compounds, aminotriazine compounds, urea compounds, amide compounds, pyrimidine compounds, and heterocycles not including nitrogen, in addition to pyridine compounds such as 4-t-butylpyridine, as an additive.

Moreover, a method of controlling the moisture content of the electrolytic solution may be employed in order to enhance the photoelectric conversion efficiency. Preferred examples of the method of controlling the moisture content include a method of controlling the concentration, and a method of adding a dehydrating agent. The moisture content (content ratio) of the electrolytic solution is preferably adjusted to 0% to 0.1% by mass.

Iodine can also be used as a clathrate compound of iodine with cyclodextrin. Furthermore, a cyclic amidine may be used, or an antioxidant, a hydrolysis inhibitor, a decomposition inhibitor, or zinc iodide may be added.

A solid-state charge transport layer such as a p-type semiconductor or a hole transport material, for example, CuI and CuNCS, may be used in place of the liquid electrolyte and the quasi-solid-state electrolyte as described above. Moreover, the electrolytes described in Nature, vol. 486, p. 487 (2012) and the like may also be used. For a solid-state charge transport layer, an organic hole transport material may be used. With regard to the organic hole transporting material, those described in paragraph No. 0214 of JP2014-139931A are preferably described, and those described in paragraph No. 0214 of JP2014-139931A are preferably incorporated herein.

The redox pair serves as an electron carrier, and therefore, it is preferably contained at a certain concentration. The concentration of the redox pair in total is preferably 0.01 mol/L or more, more preferably 0.1 mol/L or more, and particularly preferably 0.3 mol/L or more. In this case, the upper limit is not particularly limited, but is usually approximately 5 mol/L.

### <Counter Electrode>

The counter electrodes 4 and 48 preferably work as a positive electrode in a dye-sensitized solar cell. The counter electrodes 4 and 48 usually have the same configurations as the electrically conductive support 1 or 41, but in a configuration in which strength is sufficiently maintained, a substrate 44 is not necessarily required. A preferred structure of the counter electrodes 4 and 48 is a structure having a high charge collecting effect. At least one of the electrically conductive support 1 or 41 and the counter electrode 4 or 48 should be substantially transparent so that light may reach the photoconductor layers 2 and 42. In the dye-sensitized solar cell of the present invention, the electrically conductive support 1 or 41 is preferably transparent to allow solar light to be incident from the side of the electrically conductive support 1 or 41. In this case, the counter electrodes 4 and 48 more preferably have light reflecting properties. As the counter electrodes 4 and 48 of the dye-sensitized solar cell, glass or plastic on which a metal or an electrically conductive oxide is deposited is preferable, and glass on which platinum is deposited is particularly preferable. In the dye-sensitized solar cell, a lateral side of the cell is preferably sealed with a polymer, an adhesive, or the like in order to prevent evaporation of components.

### [Method for Producing Photoelectric Conversion Element and Dye-Sensitized Solar Cell]

The photoelectric conversion element and the dye-sensitized solar cell of the present invention are each preferably produced using a dye solution (the dye solution of the present invention) which contains the metal complex dye of the present invention and a solvent.

Such a dye solution is formed of the metal complex dye of the present invention dissolved in a solvent, and may also include a co-adsorbent and other components, if necessary.

Examples of the solvent to be used include the solvents described in JP2001-291534A, but are not particularly limited thereto. In the present invention, an organic solvent is preferable, and an alcohol solvent, an amide solvent, a nitrile solvent, a ketone solvent, a hydrocarbon solvent, and a mixed solvent of two or more kinds of these solvents are more preferable. As the mixed solvent, a mixed solvent of an alcohol solvent and a solvent selected from an amide solvent, a nitrile solvent, a ketone solvent, and a hydrocarbon solvent is preferable; a mixed solvent of an alcohol solvent and an amide solvent, a mixed solvent of an alcohol solvent and a hydrocarbon solvent, and a mixed solvent of an alcohol solvent and a nitrile solvent are more preferable; and a mixed solvent of an alcohol solvent and an amide solvent, and a mixed solvent of an alcohol solvent and a nitrile solvent are particularly preferable. Specifically, a mixed solvent of at least one kind of methanol, ethanol, propanol, butanol, and t-butanol, and at least one kind of dimethylformamide and dimethylacetamide, and a mixed solvent of at least one kind of methanol, ethanol, propanol, and t-butanol, and acetonitrile are preferable.

The dye solution preferably contains a co-adsorbent, and as the co-adsorbent, the aforementioned co-adsorbent is preferable.

Here, the dye solution of the present invention is preferably one in which the concentrations of the metal complex dye and the co-adsorbent have been adjusted so that the dye solution can be used as it is during production of the photoelectric conversion element or the dye-sensitized solar cell. In the present invention, the dye solution of the present invention preferably contains 0.001% to 0.1% by mass of the metal complex dye of the present invention. The amount of the co-adsorbent to be used is as described above.

For the dye solution, it is preferable to adjust the moisture content, and thus in the present invention, the moisture content is preferably adjusted 0% to 0.1% by mass.

In the present invention, it is preferable to manufacture a photoconductor layer by making the metal complex dye represented by Formula (1) or a dye including the same carried on the surface of the semiconductor fine particles, using the dye solution. That is, the photoconductor layer is preferably formed by applying (including a dip method) the dye solution onto the semiconductor fine particles provided on the electrically conductive support, followed by drying and curing.

By further providing a charge transfer layer, a counter electrode, or the like for a light-receiving electrode including the photoconductor layer as manufactured above, the photoelectric conversion element or the dye-sensitized solar cell of the present invention can be obtained.

The dye-sensitized solar cell is produced by connecting an external circuit 6 with the electrically conductive support 1 and the counter electrode 4 of the photoelectric conversion element thus manufactured.

### EXAMPLES

Hereinafter, the present invention will be described in more detail, based on Examples, but the invention is not limited thereto.

### Example 1 (Synthesis of Metal Complex Dye)

The structures of the metal complex dyes D-1 to D-20 synthesized in the present Examples are shown.

In the metal complex dye D-13, nBu represents n-butyl. This dye D-13 is described as a dye in which M¹ in Formula (1) is a tetra(n-butyl)ammonium ion and M² is a proton, and may also be either a dye in which M¹ is a proton and M² is a tetra(n-butyl)ammonium ion, or a mixture of a dye in which M¹ is a tetra(n-butyl)ammonium ion and a dye in which M² is a tetra(n-butyl)ammonium ion.

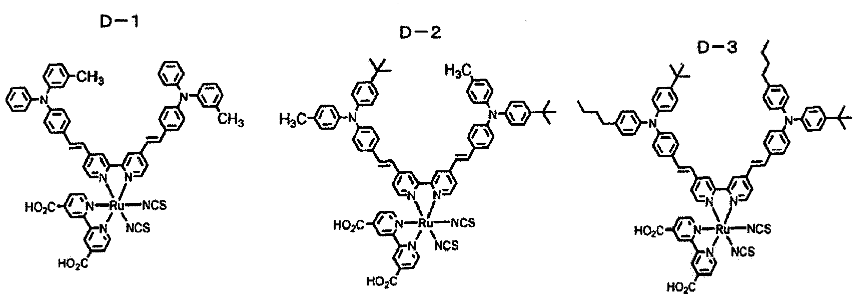

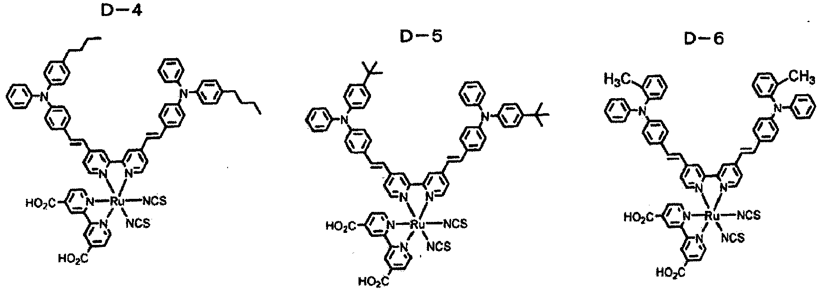

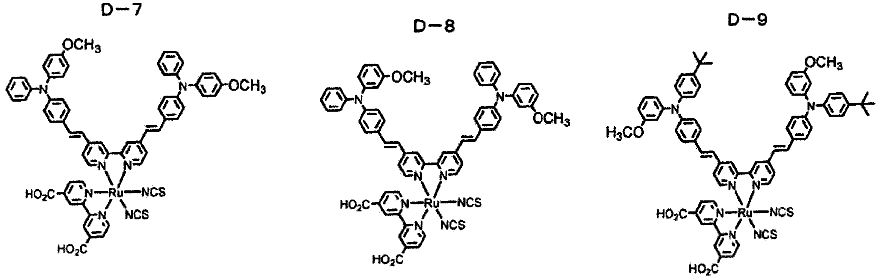

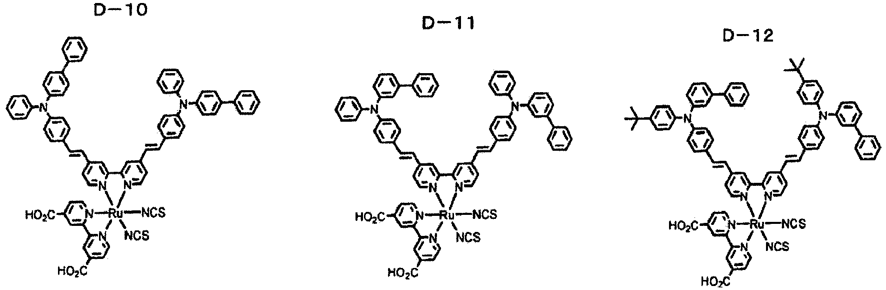

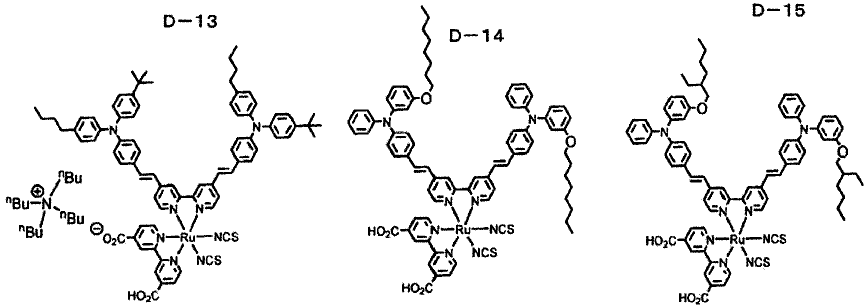

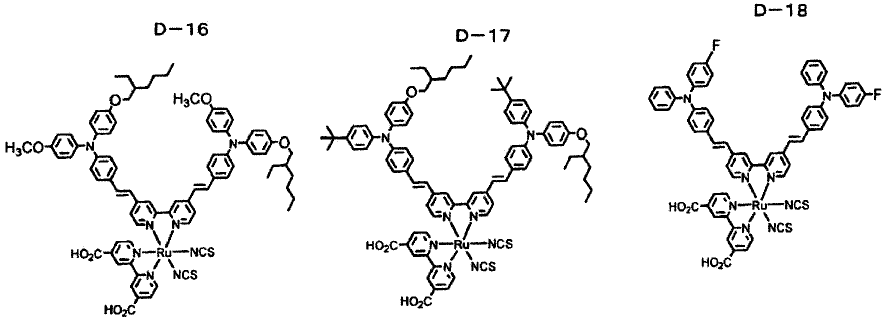

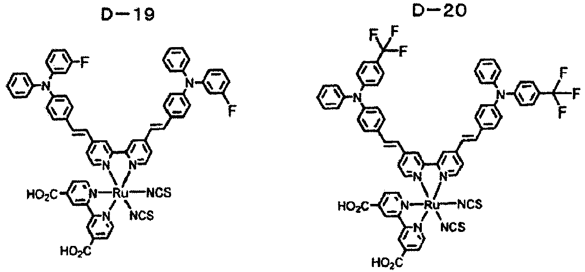

Hereinafter, a method for synthesizing the metal complex dye of the present invention will be described in detail, but the starting materials, the dye intermediates, and the synthesis routes are not limited thereto.

In the present invention, a room temperature means 25°C.

### (Synthesis of Metal Complex Dye (D-1))

According to the method of the following scheme, a metal complex dye (D-1) was synthesized.

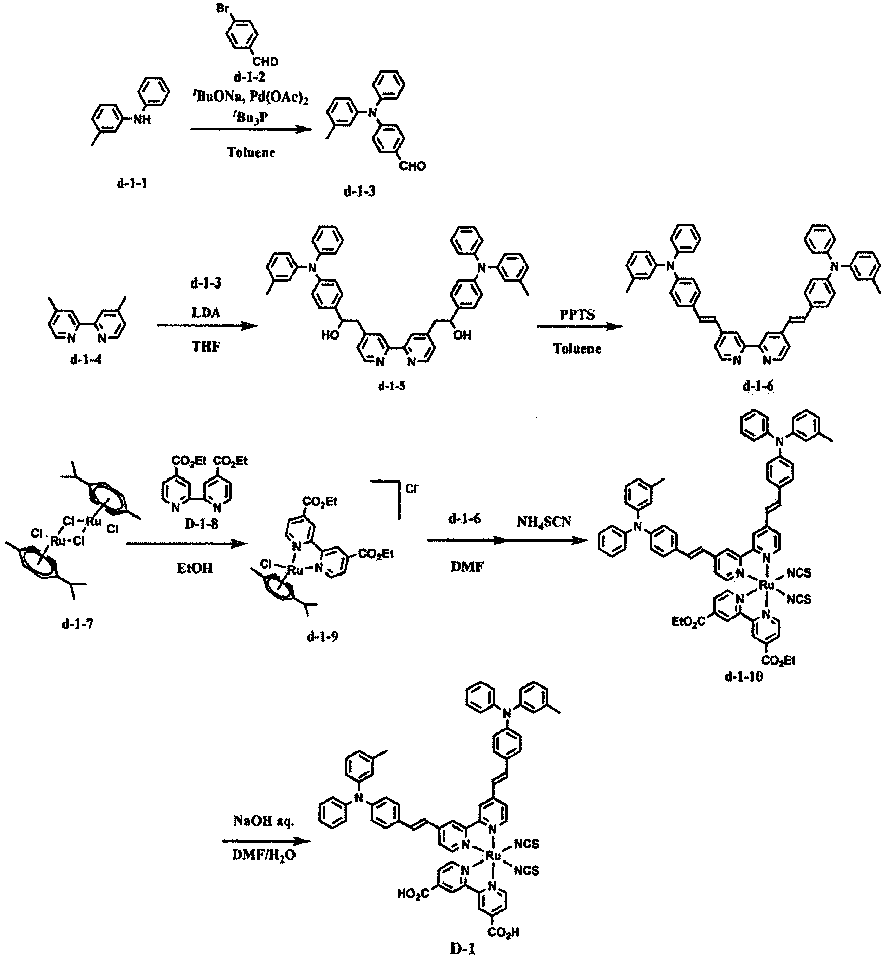

### (i) Synthesis of Compound d-1-3

18.4 g of a compound d-1-1, 18.6 g of a compound d-1-2, and 10.5 g of tert-butoxysodium were stirred at room temperature in 140 mL of toluene, and the mixture was degassed. 1.85 g of tri-tert-butylphosphine and 1.02 g of palladium (II) acetate were added thereto, and the mixture was degassed. Thereafter, the obtained mixed liquid was stirred at 100°C for 1 hour, and left to be cooled. Then, 145 mL of water, 75 mL of ethyl acetate, and 10 mL of methanol were added thereto to perform extraction and liquid separation, and saturated saline was added to the organic layer to perform liquid separation. The obtained organic layer was filtered through Celite, and the filtrate was concentrated. The obtained crude purified product was purified by silica gel column chromatography to obtain 9.0 g of a compound d-1-3.

### (ii) Synthesis of Compound d-1-5

1.41 g of a compound d-1-4 was dissolved in 56.4 mL of tetrahydrofuran (THF) at 0°C in a nitrogen gas atmosphere, and lithium diisopropylamide (LDA) which had been separately prepared was added dropwise thereto at a ratio of 2.05 equivalents with respect to the compound d-1-4, and the mixture was stirred for 75 minutes. Thereafter, to the obtained reaction solution was added dropwise a solution in which 4.4 g of the compound d-1-3 had been dissolved in 25 mL of THF, and the mixture was stirred at 0°C for 1 hour, and further stirred at room temperature for 2 hours. To the obtained liquid was added 60 mL of a saturated aqueous ammonium chloride solution, the mixture was then subjected to liquid separation, and the organic layer was concentrated. The obtained crude purified product was purified by silica gel column chromatography to obtain 0.90 g of a compound d-1-5.

### (iii) Synthesis of Compound d-1-6

840 mg of the compound d-1-5 and 556 mg of pyridinium paratoluenesulfonic acid (PPTS) were added to 4.6 mL of toluene, and the mixture was heated and refluxed for 2 hours in a nitrogen gas atmosphere. To the obtained liquid were added chloroform, methanol, and saturated sodium bicarbonate, the mixture was subject to liquid separation, and the organic layer was concentrated. The obtained crude purified product was purified by silica gel column chromatography to obtain 600 mg of a compound d-1-6.

### (iv) Synthesis of Compound d-1-9

30.6 g of a compound d-1-7 and 30.0 g of a compound d-1-8 were heated and stirred for 2 hours in ethanol, and then concentrated to obtain 60.6 g of a compound d-1-9.

### (v) Synthesis of Compound d-1-10

500 mg of the compound d-1-9 and 595 mg of the compound d-1-6 were heated and stirred at 150°C for 7 hours in 20 mL of N,N-dimethylformamide (DMF). Thereafter, to the obtained liquid was 2.5 g of ammonium thiocyanate, and the mixture was stirred at 130°C for 5 hours. The obtained reaction solution was concentrated and then water was added thereto. The mixture was filtered and the precipitate was washed with diethyl ether. The crude purified product obtained as a precipitate was purified by silica gel column chromatography to obtain 650 mg of a compound d-1-10.

### (vi) Synthesis of Metal Complex Dye D-1

To 640 mg of the compound d-1-10 was added 40 mL of DMF, 2 mL of water, and 0.8 mL of a 3 N aqueous sodium hydroxide solution, and the mixture was stirred at 30°C for 1 hour. The mixture was adjusted to pH 3.0 by the addition of a 1 N aqueous trifluoromethanesulfonic acid solution. The mixture was filtered to obtain 590 mg of a metal complex dye D-1 as a precipitate.

The structure of the obtained metal complex dye D-1 was confirmed from mass spectrum (MS) measurement results in Table 1.

### (Synthesis of Metal Complex Dyes D-2 to D-20)

By the same synthesis method as for the metal complex dye D-1, metal complex dyes D-2 to D-20 were prepared.

Each of the synthesized metal complex dyes was confirmed from MS measurement results in Table 1.

**[Table 1]**

| Table 1 | |
|---|---|
| Metal complex dye | MS (ESI⁺) |
| D-1 | MS (ESI⁺) m/z: 1185.2 ([M+H]⁺) |
| D-2 | MS (ESI⁺) m/z: 1297.4 ([M+H]⁺) |
| D-3 | MS (ESI⁺) m/z: 1381.5 ([M+H]⁺) |
| D-4 | MS (ESI⁺) m/z: 1269.3 ([M+H]⁺) |
| D-5 | MS (ESI⁺) m/z: 1269.3 ([M+H]⁺) |
| D-6 | MS (ESI⁺) m/z: 1185.2 ([M+H]⁺) |
| D-7 | MS (ESI⁺) m/z: 1217.2 ([M+H]⁺) |
| D-8 | MS (ESI⁺) m/z: 1217.2 ([M+H]⁺) |
| D-9 | MS (ESI⁺) m/z: 1329.4 ([M+H]⁺) |
| D-10 | MS (ESI⁺) m/z: 1309.3 ([M+H]⁺) |
| D-11 | MS (ESI⁺) m/z: 1309.3 ([M+H]⁺) |
| D-12 | MS (ESI⁺) m/z: 1421.4 ([M+H]⁺) |
| D-13 | MS (ESI⁺) m/z: 1381.5 ([M+H]⁺) |
| D-14 | MS (ESI⁺) m/z: 1413.5 ([M+H]⁺) |
| D-15 | MS (ESI⁺) m/z: 1413.5 ([M+H]⁺) |
| D-16 | MS (ESI⁺) m/z: 1473.5 ([M+H]⁺) |
| D-17 | MS (ESI⁺) m/z: 1525.6 ([M+H]⁺) |
| D-18 | MS (ESI⁺) m/z: 1193.2 ([M+H]⁺) |
| D-19 | MS (ESI⁺) m/z: 1193.2 ([M+H]⁺) |
| D-20 | MS (ESI⁺) m/z: 1293.2 ([M+H]⁺) |

### Example 2 (Production of Dye-Sensitized Solar Cell)

Using the metal complex dye synthesized in Example 1 or each of the following comparative compounds (C1) to (C4), a dye-sensitized solar cell 20 (in a dimension of 5 mm x 5 mm) shown in Fig. 2 was produced and its performance was evaluated according to the procedure shown below. The results are shown in Table 2.

### (Manufacture of Light-Receiving Electrode Precursor)

An electrically conductive support 41 was prepared, in which a fluorine-doped SnO₂ electrically-conductive film (transparent electrically-conductive film 43, film thickness of 500 nm) was formed on a glass substrate (substrate 44, thickness of 4 mm). Further, a glass substrate having an SnO₂ electrically-conductive film formed thereon was immersed in a 40 mM aqueous titanium trichloride solution for 30 minutes, washed with ultrapure water and ethanol, and then calcined at 450°C to form a thin film layer of the titanium oxide (metal oxide coating film, not shown in Fig. 2) on the SnO₂ electrically-conductive film. A titania paste "18NR-T" (manufactured by DyeSol) was screen-printed on the thin film layer, followed by drying at 120°C. Then, the dried titania paste "18NR-T" was screen-printed, followed by drying at 120°C for 1 hour. Thereafter, the dried titania paste was calcined at 500°C to form a semiconductor layer 45 (film thickness; 10 µm). Further, a titania paste "18NR-AO" (manufactured by DyeSol) was screen-printed on this thin film layer, and then dried at 120°C for 1 hour. Thereafter, the dried titania paste was calcined at 500°C to form a semiconductor layer 45. Further, this glass substrate was immersed in a 20 mM aqueous titanium trichloride solution for 30 minutes, and washed with ultrapure water and ethanol. A titanium oxide layer was formed on the surface of a layer formed by calcination of a titania paste "18NR-AO". Thus, a light-scattering layer 46 (film thickness: 5 µm) was formed on the semiconductor layer 45. By the procedure above, a photoconductor layer 42 (the area of the light-receiving surface; 5 mm x 5 mm, film thickness; 15 µm, a metal complex dye is not carried) was formed on the SnO₂ electrically-conductive film, thereby manufacturing a light-receiving electrode precursor not carrying a metal complex dye.

### (Dye Adsorbing Method)

Next, each of the metal complex dyes (D-1 to D-20) synthesized in Example 1 was carried onto the photoconductor layer 42 not carrying a metal complex dye in the following manner. First, the respective metal complex dyes were mixed in a mixed solvent of t-butanol and acetonitrile at 1:1 (volume ratio) such that the concentration became 2 × 10⁻⁴ mol/L. Further, 30 mol of chenodeoxycholic acid as a co-adsorbent was added to one mol of the metal complex dye, thereby preparing each of dye solutions. Next, the light-receiving electrode precursor was immersed in each of the dye solutions at 25°C for 5 hours, and dried after pulling out from the dye solution, thereby manufacturing each of light-receiving electrodes 40 having each of the metal complex dyes carried onto the light-receiving electrode precursor.

### (Assembly of Dye-Sensitized Solar Cell)

A platinum electrode (thickness of a Pt thin film; 100 nm) having the same shape and size as those of the electrically conductive support 41 was manufactured as the counter electrode 48. Further, 0.1 M (mol/L) of iodine, 0.1 M of lithium iodide, 0.005 M of 4-t-butylpyridine, and 0.6 M of 1,2-dimethyl-3-propylimidazolium iodide were dissolved in acetonitrile to prepare a liquid electrolyte as an electrolytic solution. In addition, Spacer-S (trade name: "SURLYN") manufactured by DuPont, which has a shape matching to the size of the photoconductor layer 42, was prepared.

Each of the light-receiving electrodes 40 manufactured as above and the counter electrode 48 were arranged to face each other through the Spacer S, and thermally compressed, and then the liquid electrolyte was filled from the inlet for the electrolytic solution between the photoconductor layer 42 and the counter electrode 48, thereby forming a charge transfer layer 47. The outer periphery and the inlet for the electrolytic solution of the cell thus manufactured were sealed and cured using RESIN XNR-5516 manufactured by Nagase ChemteX Corporation, thereby producing each of dye-sensitized solar cells (Sample Nos. 1 to 20).

Comparative dye-sensitized solar cells (Sample Nos. c1 to c4) were produced in the same manner as for the production of the dye-sensitized solar cells, except that each of the following comparative metal complex dyes (C1) to (C4) was used instead of the metal complex dye synthesized in Example 1 in the production of the dye-sensitized solar cell.

The metal complex dye (C1) is the compound "D-3" described in JP2001-291534A.

The metal complex dye (C2) is a dye referred to as N719. In this dye, TBA represents tetrabutylammonium.

The metal complex dye (C3) is the compound "Ru-TPA-EO-NCS" described in J. Mater. Chem., 2009, 19, p. 5364-5376.

The metal complex dye (C4) is the compound "D-1-7a" described in JP2013-072079A.

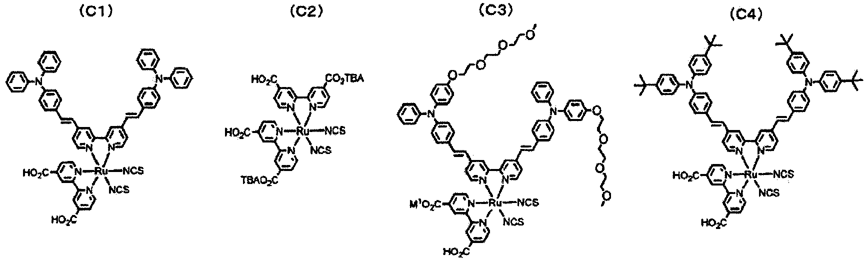

### <Evaluation of Photoelectric Conversion Efficiency ∼ Evaluation Method [A] (High-Illumination Solar Light)>

The cell characteristic test was carried out by using each of the produced dye-sensitized solar cells. The cell characteristic test was carried out by irradiating artificial solar light of 1,000 W/m² (100,000 lux) from a xenon lamp passing through an AM 1.5 filter, using a solar simulator (WXS-85H manufactured by WACOM). The current-voltage characteristics were measured using an I-V tester to determine the photoelectric conversion efficiency. The photoelectric conversion efficiency in this case is referred to as conversion efficiency [A].

For each of the dye-sensitized solar cells (Sample Nos. 1 to 20 and c1 to c4), the determined photoelectric conversion efficiency [A] was evaluated in accordance with the following standard in comparison with that of the conversion efficiency [A_{c2}] of the comparative dye-sensitized solar cell (Sample No. c2).

In the present invention, for evaluation of the conversion efficiency [A], evaluations as A and B are the acceptable levels in the present test, with A being preferable.

The conversion efficiency [A] was categorized as follows, in comparison with that of the conversion efficiency [A_{c2}].
A: More than 1.1 times
B: More than 1.0 time and 1.1 times or less
D: 1.0 time or less

The conversion efficiency [A] of each of the dye-sensitized solar cells of Sample Nos. 1 to 20 indicates that each dye-sensitized solar cell sufficiently functions as a dye-sensitized solar cell.

### <Evaluation of Photoelectric Conversion Efficiency ∼ Evaluation Method [B] (Low-Illumination Solar Light)>

The cell characteristic test was carried out by using each of the produced dye-sensitized solar cells. The cell characteristic test was carried out by irradiating artificial solar light adjusted to a predetermined illumination (1 mW/cm² (1,000 lux)) with ND filters (ND1 to ND80 manufactured by Shibuya Optical Co., Ltd.), using a solar simulator (WXS-85H manufactured by WACOM). The regulated illumination was measured using a spectrophotometer USB4000 manufactured by Ocean Photonics, Inc. The current-voltage characteristics were measured using an I-V tester to determine the photoelectric conversion efficiency. The photoelectric conversion efficiency in this case is referred to as conversion efficiency [B].

For each of the dye-sensitized solar cells (Sample Nos. 1 to 20 and c1 to c4), the determined photoelectric conversion efficiency [B] was evaluated in accordance with the following standard in comparison with that of the conversion efficiency [B_{c2}] of the comparative dye-sensitized solar cell (Sample No. c2).

In the present invention, for evaluation of the conversion efficiency [B], evaluations as A and B are the acceptable levels in the present test, with A being preferable.

The conversion efficiency [B] was categorized as follows, in comparison with that of the conversion efficiency [B_{c2}].
A: More than 1.5 times
B: More than 1.1 times and 1.5 times or less
D: 1.1 time or less

The conversion efficiency [B] of each of the dye-sensitized solar cells of Sample Nos. 1 to 20 indicates that each dye-sensitized solar cell sufficiently functions as a dye-sensitized solar (photoelectrochemical) cell under low-illumination solar light.

### <Evaluation of Photoelectric Conversion Efficiency ∼ Evaluation Method [C] (Low-Illumination Solar Light: Indoor Light)>

The cell characteristic test was carried out by using each of the produced dye-sensitized solar cells. The cell characteristic test was carried out using White LED (Product No.: LDA8N-G-K/D/60 W) manufactured by Toshiba. Adjustment of illumination (300 µW/cm² (1,000 lux)) was carried out using ND filters (ND1 to ND80) available from Shibuya Optical Co., Ltd. Measurement of the regulated illumination was confirmed using a spectrophotometer USB4000 manufactured by Ocean Photonics, Inc. The current-voltage characteristics were measured using an I-V tester to determine the photoelectric conversion efficiency. The photoelectric conversion efficiency in this case is referred to as conversion efficiency [C].

For each of the dye-sensitized solar cells (Sample Nos. 1 to 20 and c1 to c4), the determined photoelectric conversion efficiency [C] was evaluated in accordance with the following standard in comparison with that of the conversion efficiency [C_{c2}] of the comparative dye-sensitized solar cell (Sample No. c2).

In the present invention, for evaluation of the conversion efficiency [C], evaluations as S and A+ are the acceptable levels in the present test, with S being preferable.

The conversion efficiency [C] was categorized as follows, in comparison with that of the conversion efficiency [C_{c2}].
S: More than 2.0 times
A+: More than 1.7 times and 2.0 times or less
A-: More than 1.4 times and 1.7 times or less
B: More than 1.1 times and 1.4 times or less
C: 1.1 times or less

The conversion efficiency [C] of each of the dye-sensitized solar cells of Sample Nos. 1 to 20 indicates that each dye-sensitized solar cell sufficiently functions as a dye-sensitized photoelectrochemical cell under low-illumination environment.

### <Evaluation of Deviation of Conversion Efficiency>

For each of the dye-sensitized solar cells (Sample Nos. 1 to 20 and c1 to c4), three dye-sensitized solar cells were manufactured, and in the same manner as for "Evaluation of Photoelectric Conversion Efficiency ∼ Evaluation Method [C] (Low-Illumination Environment Indoor Light)", the conversion efficiency [C] was determined. In each of the dye-sensitized solar cells with Sample Nos., among the three dye-sensitized solar cells, a value calculated by dividing a value of (the highest conversion efficiency [C_{MAX}] - the lowest conversion efficiency [C_{MIN}] with the highest conversion efficiency was evaluated in accordance with the following standard.

In the present invention, in the evaluation of the conversion efficiency A, A is preferable.
A: Less than 0.1
B: 0.1 or more

**[Table 2]**

| Table 2 | | | | | | |
|---|---|---|---|---|---|---|
| Sample No. | Metal complex dye | Conversion efficiency [A] | Conversion efficiency [B] | Conversion efficiency [C] | Deviation of conversion efficiency | Note |
| 1 | D-1 | A | A | A+ | A | Present invention |
| 2 | D-2 | A | A | S | A | Present invention |
| 3 | D-3 | A | A | S | A | Present invention |
| 4 | D-4 | A | A | S | A | Present invention |
| 5 | D-5 | A | A | S | A | Present invention |
| 6 | D-6 | A | A | A+ | A | Present invention |
| 7 | D-7 | A | A | A+ | A | Present invention |
| 8 | D-8 | A | A | A+ | A | Present invention |
| 9 | D-9 | A | A | A+ | A | Present invention |
| 10 | D-10 | A | A | S | A | Present invention |
| 11 | D-11 | A | A | S | A | Present invention |
| 12 | D-12 | A | A | S | A | Present invention |
| 13 | D-13 | A | A | S | A | Present invention |
| 14 | D-14 | A | A | A+ | A | Present invention |
| 15 | D-15 | A | A | A+ | A | Present invention |
| 16 | D-16 | A | A | A+ | A | Present invention |
| 17 | D-17 | A | A | A+ | A | Present invention |
| 18 | D-18 | A | A | A+ | A | Present invention |
| 19 | D-19 | A | A | A+ | A | Present invention |
| 20 | D-20 | A | A | S | A | Present invention |
| c1 | (C1) | B | B | A- | B | Comparative Example |
| c2 | (C2) | Standard | Standard | Standard | B | Comparative Example |
| c3 | (C3) | C | C | C | B | Comparative Example |
| c4 | (C4) | B | B | A- | B | Comparative Example |

From the results of Table 2, the following findings could be obtained.

The metal complex dyes (D-1 to D-20) with a ligand having a diphenylaminostyryl skeleton which becomes asymmetrical all exhibit higher high photoelectric conversion efficiency in a high-illumination environment, and also exhibit excellent photoelectric conversion efficiency even in a low-illumination environment. In addition, the deviation of photoelectric conversion efficiency was also small.

Furthermore, the metal complex dye and the oxide semiconductor electrode of the present invention could be suitably used as a sensitizing dye and an oxide semiconductor electrode in the photoelectric conversion element and the dye-sensitized solar cell of the present invention. In addition, the dye solution of the present invention, including the metal complex dye of the present invention and a solvent, could be suitably used in the preparation of semiconductor fine particles (oxide semiconductor electrodes) as long as it carries the metal complex dye of the present invention.

To the contrary, the comparative photoelectric conversion elements and dye-sensitized solar cells (Sample Nos. c1 to c4) were not sufficient in terms of at least the conversion efficiency [C] and reduction in the deviation of photoelectric conversion efficiency. Specifically, the metal complex dyes ((C1) and (C4)) with a ligand having a diphenylaminostyryl skeleton which has a symmetrical structure were all not sufficient in terms of at least the conversion efficiency [C] and reduction in the deviation of photoelectric conversion efficiency. The metal complex dye ((C3)) with a ligand having an asymmetrical diphenylaminostyryl skeleton, and containing a 2,5,8,11-tetraoxadodecylphenyl group with four oxygen atoms was not sufficient in terms of the photoelectric conversion efficiency and reduction in a deviation thereof.

Although the present invention has been described with reference to embodiments, it is not intended that the present invention is not limited by any of the details of the description unless otherwise specified, but should rather be construed broadly within the spirit and scope of the present invention as set out in the accompanying claims.

The present application claims the priority based on Japanese Patent Application No. 2015-118149 filed on June 11, 2015, the contents of which are incorporated by reference into a part described herein.

### Explanation of References

1, 41: electrically conductive supports
2, 42: photoconductor layers (oxide semiconductor electrodes)
21: dye
22: semiconductor fine particles
3, 47: charge transfer layer
4, 48: counter electrodes
5, 40: light-receiving electrodes
6: external circuit
10: photoelectric conversion element
100: system in which photoelectric conversion element is applied to cell uses
M: operating means (for example, electric motor)
20: dye-sensitized solar cell
43: transparent electrically-conductive film
44: substrate
45: semiconductor layer
46: light-scattering layer
S: spacer

## Claims

1. A photoelectric conversion element comprising:
an electrically conductive support;
a photoconductor layer including an electrolyte;
a charge transfer layer including an electrolyte; and
a counter electrode,
wherein the photoconductor layer has semiconductor fine particles carrying a metal complex dye represented by Formula (1), 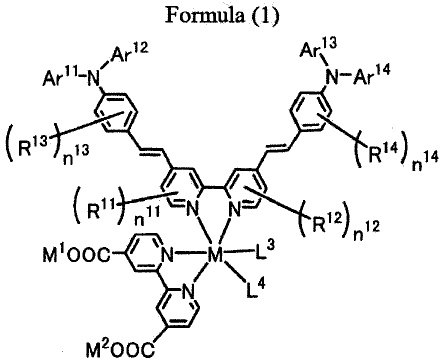
in the formula, M represents a metal ion,
Ar¹¹ to Ar¹⁴ each independently represent a phenyl group, or a phenyl group having any one of an alkyl group, an aryl group, an alkoxy group having one oxygen atom, an aryloxy group, an alkylthio group, an arylthio group, and a halogen atom, provided that Ar¹¹ and Ar¹² each represent different phenyl groups,
R¹¹ and R¹² each independently represent an alkyl group, an alkoxy group, an aryl group, an alkylthio group, a heteroaryl group, an amino group, or a halogen atom, and n¹¹ and n¹² each independently represent an integer of 0 to 3,
R¹³ and R¹⁴ each independently represent an alkyl group, an alkoxy group, an aryl group, an alkylthio group, a heteroaryl group, an amino group, or a halogen atom, and n¹³ and n¹⁴ each independently represent an integer of 0 to 4,
M¹ and M² each independently represent any one of a proton, a metal cation, and a non-metal cation, and
L³ and L⁴ each independently represent a monodentate ligand.

2. The photoelectric conversion element according to claim 1,
wherein Ar¹¹ is represented by any one of Formulae (2-1) to (2-5), and Ar¹² is represented by any one of Formulae (2-6) to (2-10), 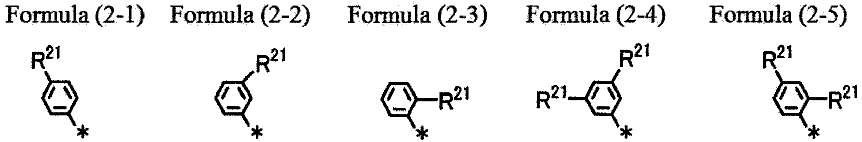
in the formulae, R²¹ represents any one of a hydrogen atom, an alkyl group, an aryl group, an alkoxy group having one oxygen atom, and a halogen atom, and * represents a bonding moiety to a nitrogen atom, and 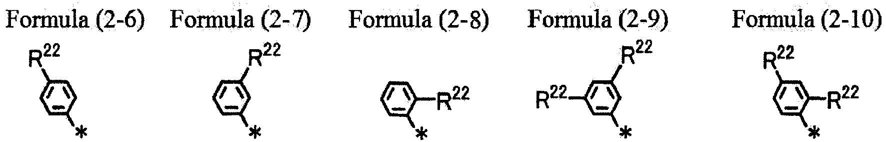
in the formulae, R²² represents any one of an alkyl group, an aryl group, an alkoxy group having one oxygen atom, and a halogen atom, and * represents a bonding moiety to a nitrogen atom.

3. The photoelectric conversion element according to claim 2,
wherein Ar¹¹ is represented by Formula (2-1) or (2-2), and Ar¹² is represented by Formula (2-6) or (2-7).

4. The photoelectric conversion element according to claim 2 or 3,
wherein Ar¹¹ and Ar¹³ are each represented by Formula (2-1) or (2-2), and Ar¹² and Ar¹⁴ are each represented by Formula (2-6) or (2-7).

5. A dye-sensitized solar cell comprising the photoelectric conversion element according to any one of claims 1 to 4.

6. A metal complex dye represented by Formula (1). 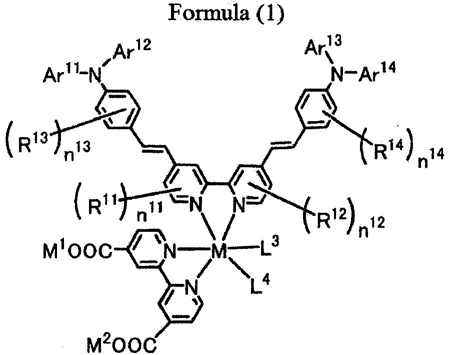
in the formula, M represents a metal ion,
Ar¹¹ to Ar¹⁴ each independently represent a phenyl group, or a phenyl group having any one of an alkyl group, an aryl group, an alkoxy group having one oxygen atom, an aryloxy group, an alkylthio group, an arylthio group, and a halogen atom, provided that Ar¹¹ and Ar¹² each represent different phenyl groups,
R¹¹ and R¹² each independently represent an alkyl group, an alkoxy group, an aryl group, an alkylthio group, a heteroaryl group, an amino group, or a halogen atom, and n¹¹ and n¹² each independently represent an integer of 0 to 3,
R¹³ and R¹⁴ each independently represent an alkyl group, an alkoxy group, an aryl group, an alkylthio group, a heteroaryl group, an amino group, or a halogen atom, and n¹³ and n¹⁴ each independently represent an integer of 0 to 4,
M¹ and M² each independently represent any one of a proton, a metal cation, and a non-metal cation, and
L³ and L⁴ each independently represent a monodentate ligand.

7. A dye solution comprising the metal complex dye according to claim 6; and a solvent.

8. An oxide semiconductor electrode comprising the metal complex dye according to claim 6.
